(19) Europäisches Patentamt
European Patent Office
Office européen des brevets

(11) **EP 4 686 948 A1**

(12) **EUROPEAN PATENT APPLICATION**

(43) Date of publication:
04.02.2026 Bulletin 2026/06

(21) Application number: 25190658.2

(22) Date of filing: **21.07.2025**

(51) International Patent Classification (IPC):
**G01R 19/00** (2006.01)  **G01R 19/165** (2006.01)
**G01R 19/25** (2006.01)

(52) Cooperative Patent Classification (CPC):
**G01R 19/16519; G01R 19/0038; G01R 19/25**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.07.2024 US 202463676543 P**

(71) Applicant: **Extropic Corp.**
**Austin TX 78757 (US)**

(72) Inventors:
• **MCCOURT, Trevor Johnathan**
**Cambridge, 02139 (US)**
• **CHAMBERLAND, Christopher Abraham**
**Austin, 78748 (US)**
• **VERDON-AKZAM, Guillaume**
**San Francisco, 94133 (US)**

(74) Representative: **Piotrowicz, Pawel Jan Andrzej et al**
**Venner Shipley LLP**
**406 Cambridge Science Park**
**Milton Road**
**Cambridge CB4 0WW (GB)**

(54) **CONFIGURING A CIRCUIT FOR GENERATING SAMPLES FROM A TARGET DISTRIBUTION**

(57) A method for configuring a circuit for generating samples from a target distribution comprises: receiving a matrix representing parameters associated with the target distribution; tuning a plurality of tunable capacitance circuits in a tunable capacitance network based at least in part on respective elements of the matrix, wherein the tunable capacitance network consists essentially of interconnected wires intersecting at a plurality of nodes with selected pairs of nodes of the plurality of nodes interconnected by a respective tunable capacitance circuit of the plurality of tunable capacitance circuits and one or more nodes of the plurality of nodes connected to a common ground by a respective tunable capacitance circuit of the plurality of tunable capacitance circuits; recording respective voltage samples from the plurality of nodes of the tunable capacitance network; and storing a linear transformation of a vector of the voltage samples based at least in part on the matrix.

**Description**

CROSS-REFERENCE TO RELATED APPLICATION(S)

This application claims priority to and the benefit of U.S. Provisional Application Serial No. 63/676,543, entitled "CONFIGURING A CIRCUIT FOR GENERATING SAMPLES FROM A TARGET DISTRIBUTION," filed July 29, 2024.

TECHNICAL FIELD

This disclosure relates to configuring a circuit for generating samples from a target distribution.

BACKGROUND

Integrated circuits (ICs) comprising interconnected components including resistors, transistors, and capacitors can be used to build electronic devices capable of performing complex operations. Some IC devices can be utilized to build electronic devices that are capable of performing computations. Compact designs coupled with advances in mass production capabilities and technologies have contributed to the widespread adoption of ICs. Current implementations of IC devices utilize metal-oxide-semiconductor (MOS) integrated circuits that are built on chip platforms typically comprising silicon. Some IC devices can be built with complementary metal-oxide-semiconductors (CMOS) comprising semiconductors doped with elements to modify their associated physical properties.
Some integrated circuits can be operated in regime wherein fundamental thermodynamic processes characterize their behavior. Some electronic devices comprising these integrated circuits can thus harness thermodynamic processes to perform operations or computations.

SUMMARY

In one aspect, in general, a method for configuring a circuit for generating samples from a target distribution comprises: receiving a matrix representing parameters associated with the target distribution; tuning a plurality of tunable capacitance circuits in a tunable capacitance network based at least in part on respective elements of the matrix, wherein the tunable capacitance network consists essentially of interconnected wires intersecting at a plurality of nodes with selected pairs of nodes of the plurality of nodes interconnected by a respective tunable capacitance circuit of the plurality of tunable capacitance circuits and one or more nodes of the plurality of nodes connected to a common ground by a respective tunable capacitance circuit of the plurality of tunable capacitance circuits; recording respective voltage samples from the plurality of nodes of the tunable capacitance network; and storing a linear transformation of a vector of the voltage samples based at least in part on the matrix.
Aspects can include one or more of the following features.
Each tunable capacitance circuit of the plurality of tunable capacitance circuits in the tunable capacitance network comprises a plurality of switchable capacitors connected in parallel and each switchable capacitor of each plurality of switchable capacitors comprises an active switching element connected in series with a corresponding capacitor.
Each active switching element of each switchable capacitor of each plurality of switchable capacitors is a transistor comprising three or more terminals including at least a first terminal connected to a voltage source of one or more voltage sources and a second terminal and a third terminal, wherein the second terminal and the third terminal are configured to connect a corresponding capacitor to the tunable capacitance network in a closed switch state and to disconnect the corresponding capacitor from the tunable capacitance network in an open switch state.
At least the first terminal of each active switching element of each switchable capacitor of each plurality of switchable capacitors is connected to the voltage source of the one or more voltage sources and the voltage source of the one or more voltage sources is configured to provide a voltage that is lower than a threshold voltage of the transistor.
Recording voltage samples is performed using one or more voltage sampling circuits configured to perform non-destructive voltage measurements.
The target distribution is a Gaussian distribution.
The linear transformation is based at least in part on one or more eigenvalues and one or more eigenvectors associated with one or more capacitors in the plurality of tunable capacitance circuits.
The linear transformation comprises transforming the vector of voltage samples based at least in part on the one or more eigenvalues and the one or more eigenvectors associated with one or more capacitors in the plurality of tunable capacitance circuits.
The linear transformation comprises iteratively calculating one or more eigenvectors using the vector of voltage samples and one or more eigenvectors associated with one or more capacitors in the plurality of tunable capacitance circuits.

In another aspect, in general, an apparatus comprises one or more voltage sources configured to provide respective voltages relative to a common ground; a tunable capacitance network consisting essentially of interconnected wires intersecting at a plurality of nodes with selected pairs of nodes of the plurality of nodes interconnected by a respective tunable capacitance circuit of a plurality of tunable capacitance circuits and one or more nodes of the plurality of nodes connected to the common ground by a respective tunable capacitance circuit of the plurality of tunable capacitance circuits, wherein: each tunable capacitance circuit of the plurality of tunable capacitance circuits comprises a plurality of switchable capacitors connected in parallel, and each switchable capacitor of each plurality of switchable capacitors comprises an active switching element connected in series with a corresponding capacitor; and at least one voltage sampling circuit connected to a corresponding node of the plurality of nodes of the tunable capacitance network configured to record one or more voltage samples.

Aspects can include one or more of the following features.

Each active switching element of a switchable capacitor of the plurality of switchable capacitors comprises a transistor having three or more terminals including at least a first terminal connected to a first voltage source of the one or more voltage sources and a second terminal and a third terminal, wherein the second terminal and the third terminal are configured to connect a corresponding capacitor to the tunable capacitance network in a closed switch state and to disconnect the corresponding capacitor from the tunable capacitance network in an open switch state.

Each transistor of an active switching element of a switchable capacitor of the plurality of switchable capacitors comprises one or more semiconductors doped with one or more electron donor elements or one or more electron acceptor elements.

The first voltage source is configured to provide a voltage that is lower than a threshold voltage of the transistor.

Each active switching element in a closed switch state is configured to individually dissipate power by a resistance between the second terminal and the third terminal of the active switching element in the closed switch state that is larger than resistances over any wires of the interconnected wires that connect any tunable capacitance circuit of the plurality of tunable capacitance circuits to any node of the plurality of nodes in the tunable capacitance network.

A voltage sampling circuit of the at least one voltage sampling circuit comprises a sense amplifier and a gain amplifier.

A voltage sampling circuit of the at least one voltage sampling circuit is configured to perform non-destructive voltage measurements that do not alter a voltage sample that is being recorded by more than 1% during a particular non-destructive voltage measurement.

Each active switching element of a switchable capacitor of the plurality of switchable capacitors comprises three or more terminals including at least a first terminal connected to one voltage source of the one or more voltage sources and a second terminal and a third terminal, wherein the second terminal and the third terminal are configured to connect a corresponding capacitor to the tunable capacitance network in a closed switch state and to disconnect the corresponding capacitor from the tunable capacitance network in an open switch state.

All closed active switching elements in switchable capacitors of the plurality of switchable capacitors in a first tunable capacitance circuit of the plurality of tunable capacitance circuits that are in a closed switch state during recording of at least one voltage sample of the one or more voltages samples are configured to: individually dissipate power by a resistance between the second terminal and the third terminal of that closed active switching element larger than resistances over any wires of the interconnected wires that connect any of the tunable capacitance circuits to any node of the plurality of nodes in the tunable capacitance network, and collectively provide an effective capacitance of the first tunable capacitance circuit of the plurality of tunable capacitance circuits that is substantially equal to a sum of capacitances of all capacitors connected to the closed active switching elements.

The selected pairs consist of all pairs of nodes of the plurality of nodes in the tunable capacitance network. Each capacitor in each switchable capacitor of the plurality of switchable capacitors in the first tunable capacitance circuit of the plurality of tunable capacitance circuits has a different capacitance from any other capacitor in any switchable capacitor of the plurality of switchable capacitors in the first tunable capacitance circuit of the plurality of tunable capacitance circuits.

Each capacitor of a plurality of capacitors in each switchable capacitor of the plurality of switchable capacitors of the first tunable capacitance circuit of the plurality of tunable capacitance circuits has a capacitance that is twice a capacitance of at least one other capacitor in any switchable capacitor of the plurality of switchable capacitors of the first tunable capacitance circuit of the plurality of tunable capacitance circuits.

Each active switching element comprises one or both of an n-type metal-oxide-semiconductor transistor, or a p-type metal-oxide-semiconductor transistor.

Each active switching element is operated using an applied voltage that is lower than a threshold voltage of the one or both of an n-type metal-oxide-semiconductor transistor or a p-type metal-oxide-semiconductor transistor associated with the active switching element.

Each voltage source connected to a respective first terminal of an active switching element is configured to provide a voltage that is lower than a threshold voltage of the one or both of an n-type metal-oxide-semiconductor transistor

or a p-type metal-oxide-semiconductor transistor associated with the active switching element.

Aspects can have one or more of the following advantages.

Some implementations of integrated circuits can comprise transistor circuits that can act as switches and allow the tuning of capacitances associated with a circuit. Some implementations of these tunable capacitance circuits can be utilized to generate samples from Gaussian distributions associated with physical behaviors arising from the hardware. Generating samples from Gaussian distributions using hardware devices can be faster and more energy efficient than generating samples via software implementations. Some hardware devices can also generate samples having distributions that more accurately reflect physical phenomena than other implementations.

Other features and advantages will become apparent from the following description, and from the figures and claims.

BRIEF DESCRIPTION OF THE DRAWINGS

The disclosure is best understood from the following detailed description when read in conjunction with the accompanying drawing. It is emphasized that, according to common practice, the various features of the drawing are not to-scale. On the contrary, the dimensions of the various features are arbitrarily expanded or reduced for clarity. The plots resulting from numerical simulations, as indicated below, are working examples of experimental results associated with some of the techniques described herein, and other plots are prophetic examples of expected experimental results.

FIG. **1** is a schematic diagram of an example transistor.

FIG. **2** is a schematic diagram of an example circuit comprising charge nodes.

FIGS. **3A-3B** are schematic diagrams of example circuits.

FIG. **4** is a schematic diagram of an example circuit comprising transistors and charge nodes.

FIGS. **5A-5D** are schematic diagrams of example CMOS transistors.

FIGS. **6A-6B** are schematic diagrams of example tunable circuits comprising CMOS transistors.

FIGS. **7A-7B** are schematic diagrams of example circuits.

FIG. **7C** is a plot of numerical simulations associated with example circuits.

FIG. **8** is a schematic diagram of an example circuit comprising island nodes.

FIGS. **9A-9B** are schematic diagrams of example circuits comprising t-gates.

FIGS. **10A-10B** are plots of numerical simulations associated with example tunable circuits.

FIG. **11** is a schematic diagram of an example tunable circuit.

FIG. **12** is a schematic diagram of an example tunable circuit that can sample from a distribution.

FIG. **13** is a flowchart of an example procedure for sampling from a distribution.

FIGS. **14A-14B** are schematic diagrams of example circuits for measuring voltages.

DETAILED DESCRIPTION

Metal-oxide semiconductor (MOS)-based transistor circuits or complementary metal-oxide semiconductor (CMOS)-based transistor circuits operating in the subthreshold regime can efficiently sample from a Gaussian distribution. In some implementations, MOS-based or CMOS-based transistor circuits can comprise t-gate circuits that act as switches and allow the tuning of the capacitances of transistor/capacitance based circuits by tuning the gate voltages of the t-gates. The effective Maxwell capacitance matrix associated with closed circuits is related to the covariance matrix of the equilibrium Gaussian distribution from which the free charge nodes may be sampled. As such, the ability to tune the Maxwell capacitance matrix results in the ability to tune the covariance matrix from which the free charge nodes are sampled. In some examples, a free charge node can refer to a node that is subject to a time evolution associated with dynamics of a circuit. In some examples, one or more circuits can be combined to form an apparatus or apparatuses.

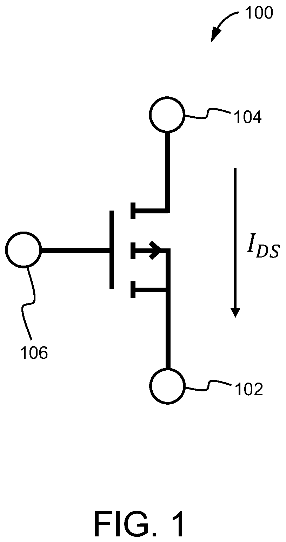

A transistor is a voltage-controlled conductor. Some transistors comprise three terminals, as shown in FIG. 1. A three-terminal transistor 100 comprises a source terminal 102, drain terminal 104, and gate terminal 106. By applying a voltage at the gate terminal 106, a current $I_{DS}$ flowing from the drain terminal 104 to the source terminal 102 can be controlled, as shown by the arrow. When a fixed voltage $V$ is applied across a resistor having a fixed resistance $R$, the current $I$ can be determined as $I = V / R$. In contrast to a resistor, the resistance of a transistor is not fixed and can depend on the voltage applied to the gate.

Some transistors can be operated or driven with a voltage below a certain threshold such that the transistor's behavior is characterized by thermodynamic processes associated with the transport of discrete charges in the transistor. By way of example, a subthreshold transistor can be operated or driven at voltages between 0 and 175 mV. This operating regime is referred to as the subthreshold or weak inversion limit. Ins some examples, this regime can also be referred to as the "sub-threshold limit." Fundamentally, the transport of discrete charges within a system can lead to shot noise. Without intending to be bound by theory, the following is an example of a theoretical model for illustrating features associated with the subthreshold limit. The current $I_{DS}$ flowing from a drain terminal 104 to a source terminal 102 for the three-terminal transistor 100 shown in FIG. 1 operating in the subthreshold limit can be written as

$$I_{DS}(V_{DS}, V_{GS}) = e(\lambda_+ - \lambda_-), \tag{1}$$

$$\lambda_+ = I_0 e^{\frac{V_{GS}}{nV_T}}, \tag{2}$$

$$\lambda_- = I_0 e^{\frac{V_{GS}}{nV_T}} e^{-\frac{V_{DS}}{V_T}}, \tag{3}$$

where $V_{DS}$ is the voltage between the drain terminal 104 and the source terminal 102, $V_{GS}$ is the voltage between the gate terminal 106 and the source terminal 102, and $I_0$ is a threshold current. In equations eqs. (2) and (3), $n$ is the slope of $I_{DS}$ in the subthreshold limit and $I_{DS}$ is linear when plotted on a log scale as a function of $e^{\frac{V_{GS}}{nV_T}}$. $\lambda_+$ in eq. (2) describes a forward hopping process for a discrete charge i.e., a discrete charge going from the drain terminal 104 to the source terminal 102. Similarly, $\lambda_-$ in eq. (3) describes a backwards hopping process i.e., a discrete charge going from the source terminal 102 to the drain terminal 104. In eqs. (2) and (3), $V_T$ corresponds to the thermal voltage and is given by

$$V_T = \frac{k_B T}{e}, \tag{4}$$

where $k_B$ is Boltzmann's constant, $T$ is the temperature of the device and $e$ is the fundamental electron charge. Shot noise can be inseparable from deterministic currents since deterministic currents can be composed of the difference between forward hopping processes and backwards hopping processes. The deterministic current can be an average measure of the noisy electron hopping. The subthreshold regime can therefore be a clean regime in which to build a thermodynamic computer since the noise is relatively well controlled.

An integrated circuit containing transistors and capacitors can localize charge to nodes of the circuit, as a transistor can regulate the stochastic transport of charge and no charge can cross a capacitor. These nodes of localized charge can be referred to as "charge nodes." In particular, transistors can pin down the relationship between voltage and charge. The formula for a voltage vector representing a voltage at each node of the circuit relative to ground, is given by

$$V = eC^{-1}m - C^{-1}C_g V_r, \tag{5}$$

where $C$, $C_g$ are matrices and $m$, $V_r$ are vectors. The matrix $C$ describes how the capacitances are distributed in the circuit and how the capacitances influence the voltage at each node when charges are present. The vector $m$ corresponds to the number of charges in each free node of the free nodes of the circuit. The matrix $C_g$ represents the gate capacitances in a circuit comprising transistors. In particular, the matrix $C_g$ connects the gate voltages of transistors to the nodes of the circuit, influencing the overall voltage distribution of the circuit. The vector $V_r$ represents the reference (or fixed) voltages applied through the gate terminals of the transistors. For a circuit containing $d$ charge nodes with $t$ transistors, $C$ is a matrix with dimensions $d \times d$ whereas $C_g$ is a $d \times t$ matrix since $C_g$ maps how each gate capacitance of a transistor influences each node. The result in eq. (5) comes from the charge and voltage equation related to the Maxwell capacitance matrix with

$$\begin{bmatrix} m \\ m_r \end{bmatrix} = \frac{V_{\text{th}}}{e} \begin{bmatrix} C & C_g \\ C_g^T & C_r \end{bmatrix} \begin{bmatrix} V \\ V_r \end{bmatrix}. \tag{6}$$

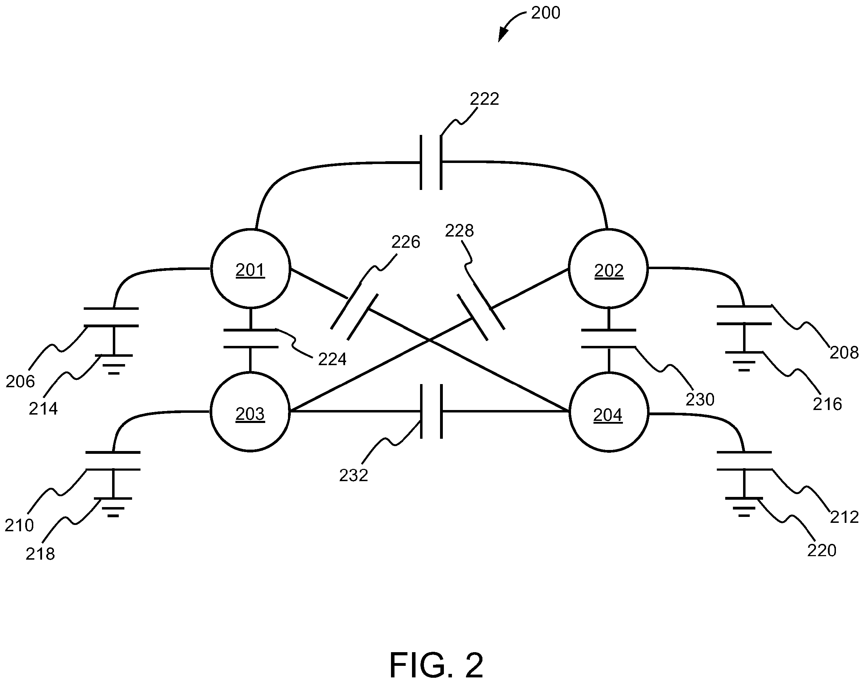

The Maxwell capacitance matrix describes the relationship between charges and voltages on a set of conductors such that

$$Q = CV, \tag{7}$$

where $C$ is the capacitance matrix, and $V$ and $Q$ correspond to the voltage vector and charge vector, respectively. An example circuit 200 comprising a plurality of nodes, i.e., a node 201, a node 202, a node 203, and a node 204, is shown in FIG. 2. In some examples, a node can be referred to as a "charge node" such that the circuit 200 comprises four charge nodes. Each of the node 201, the node 202, the node 203, and the node 204 is connected to a capacitor 206, a capacitor 208, a capacitor 210, and a capacitor 212, respectively. Each of the capacitor 206, the capacitor 208, the capacitor 210, and the capacitor 212 is connected to a ground 214, a ground 216, a ground 218, and a ground 220, respectively. Capacitors interconnect the node 201, the node 202, the node 203, and the node 204. Specifically, a capacitor 222 interconnects the node 201 and the node 202, a capacitor 224 interconnects the node 201 and the node 203, a capacitor 226 interconnects the node 201 and the node 204, a capacitor 228 interconnects the node 202 and the node 203, a capacitor 230 interconnects the node 202 and the node 204, and a capacitor 232 interconnects the node 203 and the node 204. Maxwell's equations can be used to show that the charge $Q_{201}$ on the node 201, given the voltages $V_{201}$, $V_{202}$, $V_{203}$ and $V_{204}$ on the node 201, the node 202, the node 203, and the node 204, respectively, is

$$Q_{201} = C_{206}V_{201} + C_{222}(V_{201} - V_{202}) + C_{224}(V_{201} - V_{203}) + C_{226}(V_{201} - V_{204})$$

$$= (C_{206} + C_{222} + C_{224} + C_{226})V_{201} - C_{222}V_{202} - C_{224}V_{203} - C_{226}V_{204}, \tag{8}$$

so that the first row of the capacitance matrix is given by

$$\begin{bmatrix} C_{206} + C_{222} + C_{224} + C_{226} & -C_{222} & -C_{224} & -C_{226}. \end{bmatrix} \tag{9}$$

Extending the above to all nodes, the capacitance matrix can be written

$$\begin{bmatrix} C_{206} + C_{222} + C_{224} + C_{226} & -C_{222} & -C_{224} & -C_{226} \\ -C_{222} & C_{222} + C_{208} + C_{228} + C_{230} & -C_{228} & -C_{230} \\ -C_{224} & -C_{228} & C_{224} + C_{228} + C_{210} + C_{232} & -C_{232} \\ -C_{226} & -C_{230} & -C_{232} & C_{226} + C_{230} + C_{232} + C_{212} \end{bmatrix}$$

$$\tag{10}$$

In general, for a circuit with arbitrary nodes, an off diagonal element $C_{ij}$ in the capacitance matrix represents the mutual capacitance between node $i$ and node $j$. The negative sign indicates that an increase in the voltage at node $j$ effectively decreases the "effective" charge due to this mutual capacitance at node $i$, thus acting in opposition to the voltage at node $i$. For the diagonal elements in the capacitance matrix, $C_{ii}$ represents the total capacitance connected to node $i$, including any capacitors that are connected to node $i$ and ground.

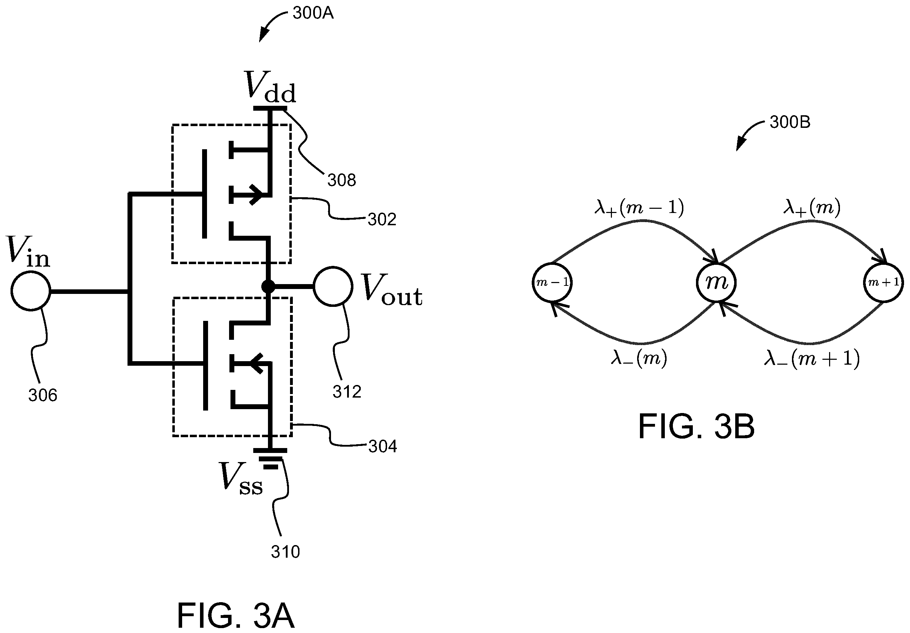

For some circuits containing charge nodes, the changes in the number of electron charges at each node can be modeled through a Markov process. An example circuit 300A is depicted in FIG. 3A. The circuit 300A comprises a first transistor 302, a second transistor 304, a node 306, a node 308, a node 310, and a node 312 is shown in FIG. 3A. In some examples, these nodes can be referred to as "charge nodes." The circuit 300A is one-dimensional since only the node 312 with voltage $V_{out}$ is free, as each of the node 306, the node 308, and the node 310 is clamped to the voltages $V_{in}$, $V_{dd}$ and $V_{ss}$ respectively. In some examples, a clamped node can refer to a node that has a voltage that is fixed by an external source. The number of charges on the node 312 is the degree of freedom of the circuit. Both the first transistor 302 and the second transistor 304 can fire and pull charges on or off the node 312. The probability of finding the node 312 in state $m$ per unit time is given by

$$\frac{\partial p(m)}{\partial t} = -(\lambda_+(m) + \lambda_-(m))p(m) + \lambda_+(m-1)p(m-1) + \lambda_-(m+1)p(m+1), \quad (11)$$

with an illustration of the Markov process 300B shown in FIG. 3B. Flow away from the charge state $m$ occurs with probability per unit time given by $(\lambda_+(m) + \lambda_-(m))p(m)$. Similarly, flow to state $m$ from state $m$ - 1 occurs with probability per unit time $\lambda_+(m-1)p(m-1)$ and flow to state $m$ from state $m$ + 1 occurs with probability per unit time $\lambda_-(m+1)p(m+1)$.

In general, a circuit can have many degrees of freedom that correspond to the number of unclamped nodes in the circuit. A general master equation describing the time evolution of the stochastic system can be written as

$$\frac{\partial p(m,t)}{\partial t} = \mathcal{L}(U_{\text{in}})p(m,t), \quad (12)$$

where the linear operator $\mathcal{L}(U_{\text{in}})$ can be written as

$$\mathcal{L}(U_{\text{in}}) = -\sum_{\rho}(\lambda_-^{\rho}(m, U_{\text{in}}) + \lambda_+^{\rho}(m, U_{\text{in}}))p(m,t) + \lambda_-^{\rho}(m + v_{\rho}, U_{\text{in}})p(m + v_{\rho}, t)$$

$$+ \lambda_+^{\rho}(m - v_{\rho}, U_{\text{in}})p(m - v_{\rho}, t). \quad (13)$$

In eq. (13), the sum over $\rho$ is a sum over all transistors in the circuit. The vector $v_{\rho}$ describes what a transistor (labeled $\rho$) does to the circuit. A transistor may pull away charges from a subset of nodes and add charges to another subset of nodes. The terms involving $\lambda_+^{\rho}$ and $\lambda_-^{\rho}$ depend explicitly on the node voltages as can be seen from eqs. (2) and (3). As such the $\lambda$'s can be written as functions of V and $m$ using eq. (5).

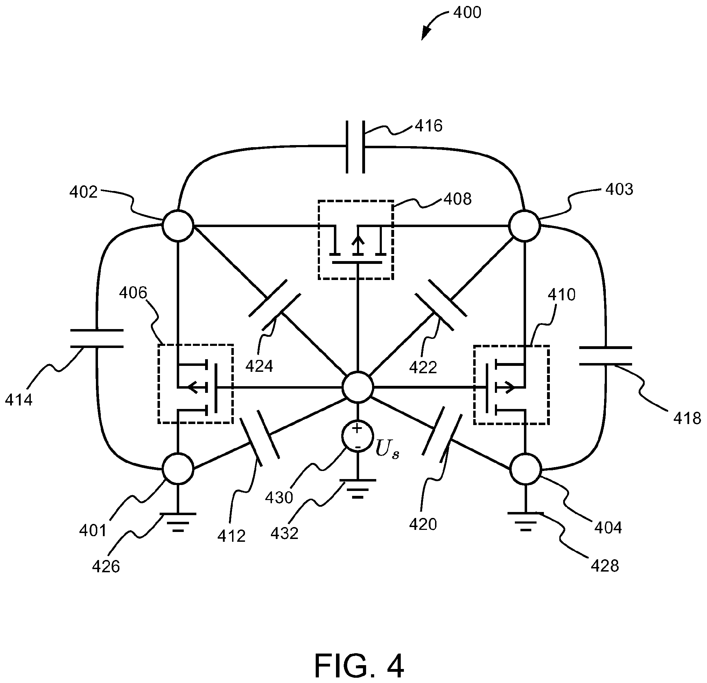

An example circuit 400 comprising a node 401, a node 402, a node 403, and a node 404 is shown in FIG. 4. The circuit 400 comprises a transistor 406, a transistor 408, a transistor 410, a capacitor 412, a capacitor 414, a capacitor 416, a capacitor 418, a capacitor 420, a capacitor 422, and a capacitor 424. Node 401 is connected to ground 426 and node 404 is connected to a ground 428. The input voltage supply 430 connected to ground 432 provides an input voltage $U_{\text{in}} = U_s$. The node 402 and the node 403 are "free," i.e., they are not clamped to ground or the input voltage such that $m = (m_{402}, m_{403})$. For the transistor 406 connected to node 401 and node 402 with $\rho = 1$, the transistor 406 can either cause a charge to be added or removed from node 402, corresponding to $v_{406} = (1, 0)$ or $-v_{406} = (-1,0)$ respectively. Both possibilities are accounted for in eq. (13) with the terms $\lambda_-^{\rho}(m + v_{\rho}, U_{\text{in}})$ and $\lambda_+^{\rho}(m - v_{\rho}, U_{\text{in}})$. Similarly, for the transistor 408 connected to the node 402 and the node 403 with $\rho = 2$, the transistor 408 can cause a charge to be removed from the node 403 and added to the node 402 such that $v_{408} = (1, -1)$). Alternatively, the transistor 408 can cause a charge to be removed from the node 402 and added to the node 403, such that $-v_{408} = (-1, 1)$). The sum over $\rho$ would be a sum over three terms since the circuit 400 comprises the transistor 406, the transistor 408, and the transistor 410.

In addition to considering the dynamics of the probability distribution for the state $m$ as in eq. (12), the trajectories for the state $m$ can also be considered. The change in the state $m$ from time $t$ to time $t$ + $dt$ can be written as

$$m(t + dt) = m(t) + \sum_{\rho}\sum_{\alpha=\pm}\alpha v_{\rho}\mathcal{P}(\lambda_{\alpha}^{\rho}(m)dt), \quad (14)$$

where P is a Poisson random variable with rate $\lambda_{\alpha}^{\rho}(m)dt$. In other words, the charge vector evolves according to infinitesimal Poissonian jumps, and the terms $\lambda_{\alpha}^{\rho}(m)$ can be viewed as the instantaneous probability of making a transition per unit time. Therefore, $\lambda_{\alpha}^{\rho}(m)dt$ is the probability of a transistor causing a change in the charge state in time $dt$. Further the $\alpha$ term accounts for the transistor firing in either the forward or reverse direction.

Some circuits can be closed and/or isothermal. A closed circuit refers to a circuit wherein none of the conductors (charge degrees of freedom) have their potentials fixed by voltage sources. An isothermal circuit has a temperature that remains constant. Without intending to be bound by theory, the following is an example of a theoretical model for illustrating features associated with closed and isothermal circuits. A Gibbs state associated with a closed and isothermal circuit can be an equilibrium state of the master equation in eq. (12). The Gibbs state can be written

$$P_{\text{Gibbs}}(m,t) = \frac{e^{-\beta E(m)}}{Z} \prod_v \delta\left[L_v(m), L_v(m^{(i)})\right],\qquad(15)$$

where $m^{(i)}$ is the initial charge state of the system, $\delta[a, b] = 1$ if $a = b$ and 0 otherwise, and $v$ runs over the set of independent conservation laws. The energy $E$ in eq. (15) corresponds to the electrostatic energy. The conservation laws $L_v(m)$ are written as

$$L_v(m) = l_v^T m,\qquad(16)$$

where $l_v^T \Delta = 0$ with $\Delta$ being the matrix of column vectors $\Delta = [\Delta_1,\cdots,\Delta_M]$ with each $\Delta_\rho$ for transistor $\rho$ specifying the transition $m \to m + \Delta_{\pm\rho}$. For a closed and isothermal circuit, $(\Delta_{\pm\rho})_k = -\delta_{k,n} + \delta_{k,m}$. For $P_{\text{Gibbs}}(m, t)$ to be an equilibrium state when the circuit is closed and isothermal imposes conditions on the transition rates $\lambda_{\pm}^\rho(m,t)$. Such conditions correspond to the local detailed balance (LDB) conditions which can be expressed for each transistor $\rho$ as

$$\log\frac{\lambda_+^\rho(m,t)}{\lambda_-^\rho(m+\Delta_\rho,t)} = -\beta\left(E(m+\Delta_\rho) - E(m)\right),\qquad(17)$$

The Gibbs distribution in eq. (15) contains the product $\Pi_v[L_v(m), L_v(m^{(i)})]$. For all circuits considered in this work, $L_v(m^{(i)}) = L_v(m)$. Consequently, in what follows, this term is omitted.

A charge vector at each node of a circuit can be related to a voltage vector at each node as

$$Q = CV.\qquad(18)$$

For a circuit with $N$ conductors, $Q = (q_1,\cdots,q_N)^T$ and $V = (V_1,\cdots,V_N)^T$. $C$ is the $N \times N$ Maxwell capacitance matrix. The electrostatic energy $E$ contained in such circuits is given by

$$\begin{aligned}E &= \frac{1}{2}Q^T V\\ &= \frac{1}{2}V^T C V\\ &= \frac{1}{2}Q^T C^{-1} Q,\end{aligned}\qquad(19)$$

where the second and third lines of eq. (19) were determined using eq. (18) and the relation $C = C^T$. Inserting eq. (19) into eq. (15), the Gibbs state can be written

$$P_{\text{Gibbs}}(m,t) = \frac{e^{-\frac{\beta e^2}{2}m^T C^{-1} m}}{Z}.\qquad(20)$$

From eq. (20), for closed and isothermal circuits, measuring a charge state can produce samples of a Gaussian distribution with covariance matrix given by in the inverse of the capacitance matrix, $C^{-1}$.

Some circuits can incorporate n-type metal-oxide-semiconductor (nMOS) or p-type metal-oxide-semiconductor (pMOS) transistors. nMOS transistors comprise semiconductors doped with an electron donor element, such as phosphorus, arsenic or antimony. pMOS transistors comprise semiconductors doped with an electron acceptor element such as boron, aluminum, or gallium.

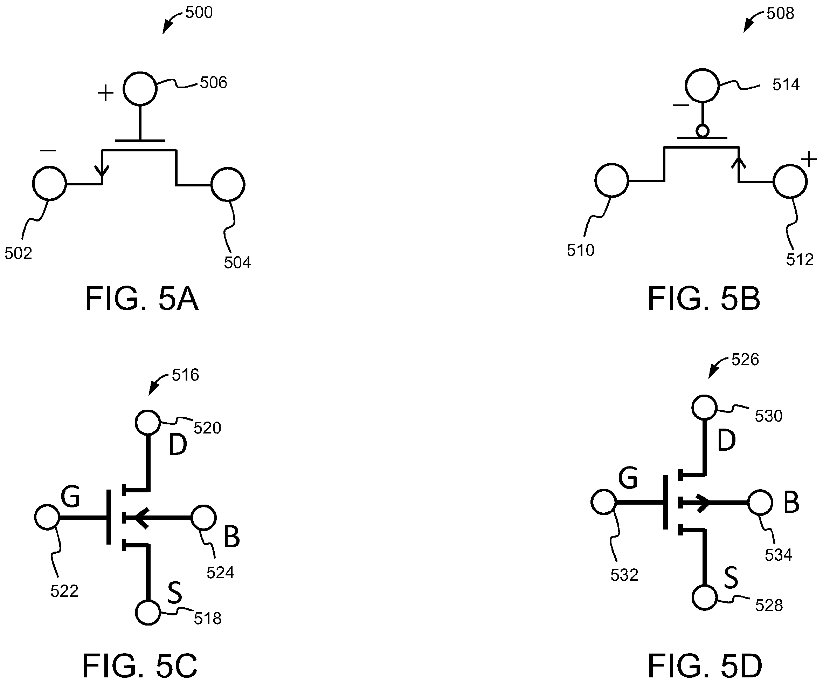

FIG. 5A depicts an example nMOS transistor 500 comprising a source terminal 502 associated with a voltage $V_S$,

a drain terminal 504 associated with a voltage $V_D$, and a gate terminal 506 associated with a voltage $V_g$. nMOS transistors typically have positive threshold voltages $V_T$. An nMOS transistor can act as a short, or conduct, when $V_g$ - $V_S$ > $V_T$ and act as open circuits when $V_g$ - $V_S$ < $V_T$. nMOS transistors can have $V_D$ > $V_S$ and can source current to the load. The voltage $V_S$ associated with the source terminal 502 can be low (near or at ground) to ensure the above conditions can easily be satisfied.

FIG. 5B depicts an example pMOS transistor 508 comprising a source terminal 510 associated with a voltage $V_S$, a drain terminal 512 associated with a voltage $V_D$, and a gate terminal 514 associated with a voltage $V_g$. pMOS transistors typically have negative threshold voltages (i.e. $V_T$ < 0). A pMOS transistor can act as a short, or conduct, when $V_g$ - $V_S$ < - | $V_T$| and can act as an open circuit when $V_g$ - $V_S$ > - $|V_T|$. For pMOS transistors, $V_S$ can be large to ensure that $V_g$ - $V_S$ conditions can more easily be satisfied. In addition, pMOS transistors can have $V_D$ < $V_S$ such that current is sunk from the load to the source. By tuning the source and gate voltages of nMOS and pMOS transistors, a circuit can thus act as a short or open circuit.

Some nMOS and pMOS transistors have four terminals. FIG. 5C depicts an nMOS transistor 516 comprising four terminals, i.e., a source terminal 518, a drain terminal 520, a gate terminal 522, and a body terminal 524. Transition rates associated with a four terminal nMOS device can be expressed using $\lambda_0 = \frac{I_0}{e}$ and $U_k = \frac{V_k}{V_{\text{th}}}$. For an nMOS device,

$$\lambda_{\text{DS}}^{\text{nMOS}} = \lambda_0 e^{\frac{U_G - U_B}{n}} e^{U_B - U_S} \tag{21}$$

$$\lambda_{\text{SD}}^{\text{nMOS}} = \lambda_0 e^{\frac{U_G - U_B}{n}} e^{U_B - U_D}. \tag{22}$$

FIG. 5D depicts a pMOS transistor 526 comprising four terminals, i.e., source terminal 528, a drain terminal 530, a gate terminal 532, and a body terminal 534. For a pMOS device, a transition rate can be expressed using the relation $\lambda_0 = \frac{I_0}{e}$ and $U_k = \frac{V_k}{V_{\text{th}}}$ as

$$\lambda_{\text{DS}}^{\text{pMOS}} = \lambda_0 e^{\frac{U_B - U_G}{n}} e^{U_D - U_B} \tag{23}$$

$$\lambda_{\text{SD}}^{\text{pMOS}} = \lambda_0 e^{\frac{U_B - U_G}{n}} e^{U_S - U_B}. \tag{24}$$

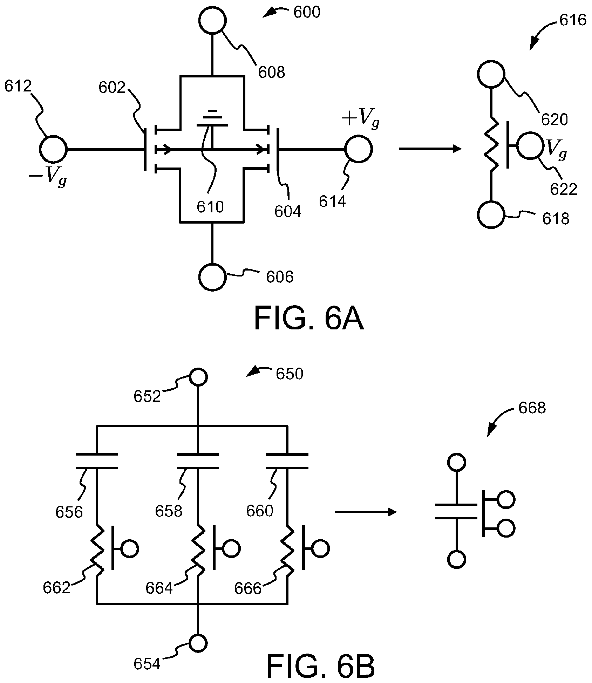

Some circuits can effectively act as tunable resistors by combining nMOS and pMOS transistors. FIG. 6A depicts a circuit 600 that can act as a tunable resistor comprising a pMOS transistor 602 and a nMOS transistor 604. In some implementations, the circuit 600 can be referred to as a "tunable resistance circuit." Each of the pMOS transistor 602 and the nMOS transistor 604 respectively comprises four terminals. The source terminals of the pMOS transistor 602 and the nMOS transistor 604 are connected at a node 606 and drain terminals of the pMOS transistor 602 and the nMOS transistor 604 are connected at a node 608. The body terminals of the pMOS transistor 602 and the nMOS transistor 604 are connected to a ground 610. For the nMOS transistor 604, $V_g$ can be applied to the gate terminal 614 while for the pMOS transistor 602, -$V_g$ can be applied to the gate terminal 612. In this setting, the resulting circuit behaves as a tunable resistor. In more complex circuit diagrams, the circuit 600 can be simplified and represented as circuit 616 comprising a source terminal 618, a drain terminal 620, and a gate terminal 622. The current $I_{\text{DS}}$ from the drain terminal 620 to the source terminal 618 in the circuit 616 is given by

$$\frac{I_{\text{DS}}}{e} = \lambda_{\text{DS}} - \lambda_{\text{SD}} = 4\lambda_0 e^{\frac{U_g}{n}} \cosh U_\Sigma \sinh U_\Delta, \tag{25}$$

where $U_g = V_g/V_T$ and

$$U_\Sigma = \frac{U_D + U_S}{2} \tag{26}$$

$$U_\Delta = \frac{U_D - U_S}{2} \qquad (27)$$

with $U_\Sigma$, $U_\Delta < 1$. Note that in deriving eq. (25), the symmetry of the circuit was used to write $\lambda_{DS} = \lambda_{DS}^{pMOS} + \lambda_{DS}^{nMOS}$ and $\lambda_{SD} = \lambda_{SD}^{pMOS} + \lambda_{SD}^{nMOS}$ with such terms given in eqs. (21) to (24). For completeness,

$$\lambda_{DS} + \lambda_{SD} = 4\lambda_0 e^{\frac{U_g}{n}} \cosh U_\Sigma \cosh U_\Delta, \qquad (28)$$

and

$$U_\Delta = \frac{e^{-\frac{U_g}{n}}}{4e\lambda_0} I_{DS}, \qquad (29)$$

where the term $\frac{e^{-\frac{U_g}{n}}}{4e\lambda_0} \sim R$ can be interpreted as an effective resistance. From eqs. (25) and (29), when $V_g \gg 1$, the effective resistance is near zero and thus the circuit 616 in FIG. 6A behaves as a short circuit. On the other hand, when $V_g$ has a large negative value, the effective resistance is very large and thus the circuit 616 in FIG. 6A behaves as an open circuit. Consequently, a switch can be build out of two transistors. Such considerations for the voltages $V_g$ for closed vs open circuits determines important time scales for the dynamics of the circuit. To obtain a short circuit, $\lambda_0 e^{\frac{U_g}{n}}$ must be greater than the effective transition rates for the other circuit components to which the circuit 616 in FIG. 6A is connected as module.

At first glance the circuit 616 in FIG. 6A is not closed due to the voltages $-V_g$ and $V_g$. However, the circuit is closed because no current flows through the gate nominally. As such, the closed circuit conditions to sample from a Gaussian distribution are still satisfied.

In general, a transistor-based circuit that can act as a switch, such as the circuits shown in FIGS. 5A-5D and FIG. 6A, can be referred to as a $t$-gate switch or a $t$-gate circuit. Using a combination of the $t$-gate switches in FIGS. 5A-5D or FIG. 6A, a simple programmable capacitor can be built. An example circuit 650 configured as a programmable capacitor is shown in FIG. 6B. The circuit 650 comprises a node 652 and a node 654 between which a capacitor 656, a capacitor 658, and a capacitor 660 are connected in parallel. Each of the capacitor 656, the capacitor 658, and the capacitor 660 is connected in series with a switch 662, a switch 664, and a switch 666, respectively. Each of the switch 662, the switch 664, and the switch 666 can comprise a respective tunable resistor circuit such as circuit 600 in FIG. 6A. If all the switch 662, the switch 664, and the switch 666 are open, circuit 650 is open. If one of the switch 662, the switch 664, or the switch 666 is closed, the capacitor 656, the capacitor 658, or the capacitor 660 connected to the closed switch is connected. Likewise, if two of the switch 662, the switch 664, or the switch 666 are closed, the circuit 650 can have two of the capacitor 656, the capacitor 658, or the capacitor 660 connected in parallel, which results in a capacitance $C_i + C_j$ where $i$ and $j$ correspond to the indices of the two closed switches. If all three of the switch 662, the switch 664, the switch 666 are closed, the total capacitance is $C_1 + C_2 + C_3$. Although FIG. 6B has three capacitors, in general, an arbitrary number of capacitors connected in parallel can be used, with the exact number depending on the particular application being considered, i.e., by the total desired variability in the tunable capacitance device. In such cases with an arbitrary number of capacitors, each capacitor can also be connected in series with a switching element. In more complex circuit diagrams, a tunable capacitor circuit such as the circuit 650 can be depicted as the circuit element 668.

In some $t$-gate circuits, each of the switch 662, the switch 664, and the switch 666 can comprise the nMOS transistor 500, the nMOS transistor 516, the pMOS transistor 508, or the pMOS transistor 526 in FIGS. 5A-5D. Alternatively, each of the switch 662, the switch 664, and the switch 666 can comprise the circuit 600 in FIG. 6A which is built out of both a pMOS transistor and an nMOS transistor. A switch including a transistor can comprise three or more terminals including a first terminal that is connected to a voltage source and a second terminal and a third terminal. If the switch is connected to a capacitor, the second terminal and the third terminal can be configured to connect a corresponding capacitor to the tunable capacitance network in a closed switch state and to disconnect the corresponding capacitor from the tunable capacitance network in an open switch state. If the voltages at the source nodes $V_S$ (or drain nodes) are fixed throughout a computation, then an nMOS circuit can be used as a switch if $V_S$ is small, since the $V_g > V_S + V_T$ condition can be easier to satisfy. Alternatively, a pMOS circuit can be used if $V_S$ is large, since the $V_g - V_s < -|V_T|$ condition can be easier to satisfy. If $V_S$ is dynamical throughout the computation, then using a circuit such as that depicted in FIG. 6A as a *t*-gate switch can be advantageous.

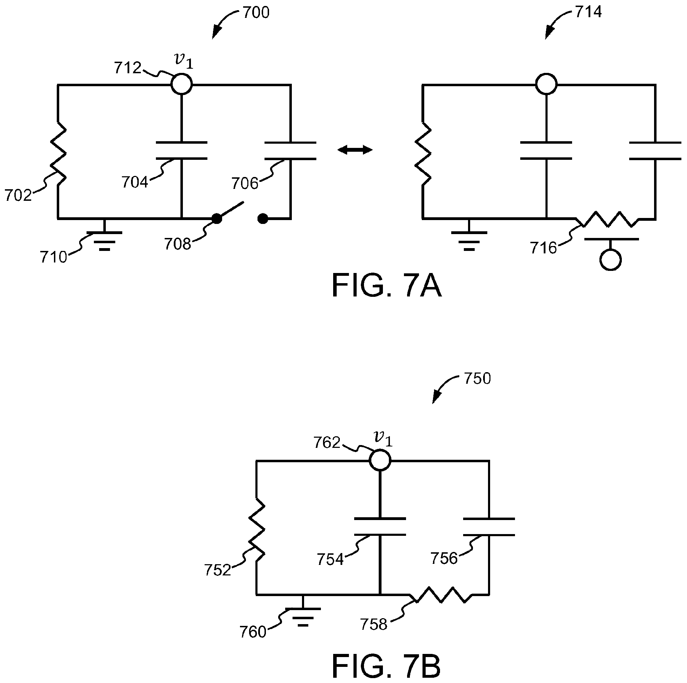

Referring again to the example t-gate circuit shown in FIG. 6B, the circuit properties (whether the circuit is open or short) depends on the voltage $V_g$. When $V_g/V_{th}$ is large, the switch made of transistors has an effective resistance which is non-zero. The effects of this non-zero resistance can be demonstrated by circuit 700 shown in FIG. 7A and the circuit 750 shown in FIG. 7B. The circuit 700 comprises a resistor 702 connected in parallel to a capacitor 704 and a capacitor 706. The resistor 702 is associated with a resistance $R_1$ while the capacitor 704 is associated with a capacitance $C_1$ and the capacitor 706 is associated with a capacitance $C_2$. A node 712 of the circuit 700 is associated with equilibrium statistics $v_1$. The circuit 700 further comprises a switch 708 that can be implemented as a tunable resistor 716 as depicted in circuit 714. The circuit 700 is also connected to a ground 710. The circuit 700 and the circuit 714 are functionally equivalent.

For large values of $V_g$, the effective resistance associated with the switch 708 is not zero, resulting in the switch 708 in circuit 700 behaving as a resistor 758 associated with a resistance $R$ in circuit 750 in FIG. 7B. The circuit 750 comprises a resistor 752 associated with a resistance $R_1$ connected in parallel to a capacitor 754 associated with a capacitance $C_1$ and a capacitor 756 associated with a capacitance $C_2$. The circuit 750 is connected to a ground 760. The equilibrium statistics of a node 762 or $v_1$ in FIG. 7B can be expressed as

$$P(v_1) \propto e^{-(\beta/2)v_1^2/C_1}. \tag{30}$$

If the transistor acted as a true short with zero effective resistance as shown in FIG. 7A, the equilibrium statistics $v_1$ of the node 712 would be

$$P(v_1) \propto e^{-(\beta/2)v_1^2/(C_1+C_2)} \tag{31}$$

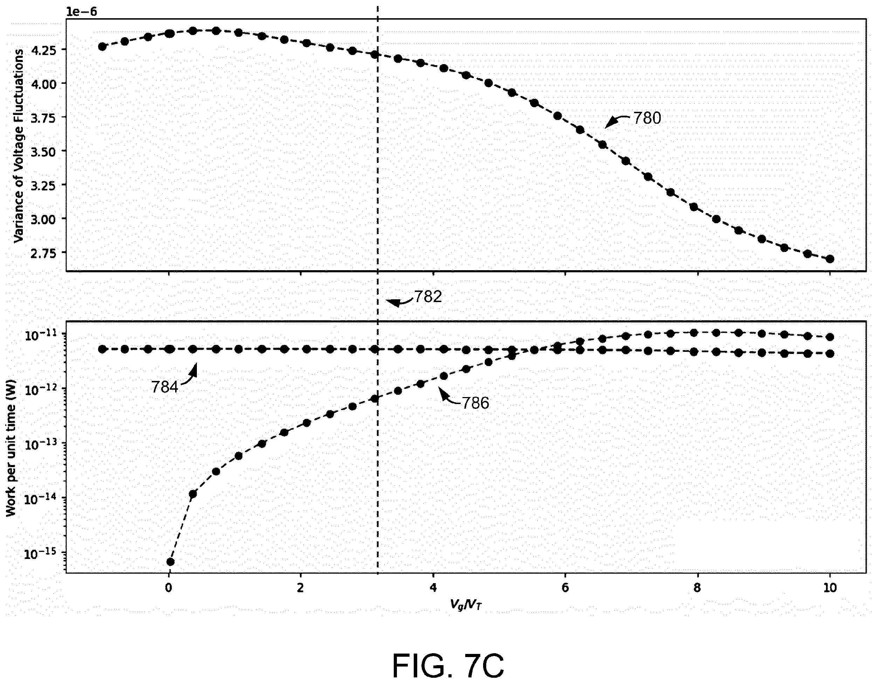

The equilibrium distribution in eq. (31) should be recovered from the one in eq. (30) by taking the limit where $R \to 0$. However the distribution in eq. (31) is independent of $R$. FIG. 7C depicts plots of numerical simulations associated with operating circuits. A trace 780 depicts the variance of voltage fluctuations of the node $v_1$ as a function of $V_g/V_{th}$. FIG. 7C also depicts a trace 784 of the work per unit time for a resistor root mean square power as a function of $V_g/V_{th}$ and a trace 786 of the work per unit time for a switch power draw as a function of $V_g/V_{th}$. Dashed line 782 indicates an approximate value for $V_g/V_{th}$ when the gate power is within an order of magnitude of the noise fluctuations, or the point at which a *t*-gate starts to behave as a short. As shown by the plots in FIG. 7C, when $V_g/V_{th}$ is large, the *t*-gate starts to use power and does work on the system. As such, the system no longer goes to equilibrium and thus the *t*-gate behaves as a true short circuit. The short works as expected since the voltage fluctuations get cut in half. Consequently, in what follows, *t*-gates can be assumed to behave as true short and open circuits when considering their effect on the effective capacitance of a given circuit.

In some implementations of *t*-gate circuits, a circuit can comprise free nodes, regulated nodes, and island nodes. A circuit comprising one or more island nodes can have an localized charge around the one or more island nodes. In such circuits, the voltage covariance of relevant degrees of free is identical to the shorted case if the *t*-gate circuits do not behave as a true short. Without intending to be bound by theory, the following is an example of a theoretical model for illustrating features.

Charge and voltage vectors for free, regulated, and island nodes can be defined as $(q_f, V_f)$, $(q_r, V_r)$ and $(q_i, V_i)$. The charge and voltage vectors are related by the Maxwell capacitance matrix as

$$\begin{bmatrix} q_f \\ q_r \\ q_i \end{bmatrix} = \begin{bmatrix} C_f & C_{fr} & C_{fi} \\ C_{fr}^T & C_r & C_{ri} \\ C_{fi}^T & C_{ri}^T & C_i \end{bmatrix} \begin{bmatrix} V_f \\ V_r \\ V_i \end{bmatrix}. \tag{32}$$

Performing the matrix multiplications in eq. (32), results in

$$V_i = C_i^{-1} q_i - C_i^{-1} C_{fi}^T V_f - C_i^{-1} C_{ri}^T V_r, \tag{33}$$

$$q_r = C_{fr}^T V_f + C_r V_r + C_{ri} V_i, \tag{34}$$

$$C_f V_f = q_f - C_{\mathrm{fr}} V_r - C_{\mathrm{fi}} V_i. \qquad (35)$$

Inserting eq. (33) into eq. (35),

$$q_f - C_{\mathrm{fi}} C_i^{-1} q_i = \left( C_f - C_{\mathrm{fi}} C_i^{-1} C_{\mathrm{fi}}^T \right) V_f + (C_{\mathrm{fr}} - C_{\mathrm{fi}} C_i^{-1} C_{\mathrm{ri}}^T) V_r. \qquad (36)$$

From eq. (36) the adjusted free capacitance matrix can be defined as

$$C_{\mathrm{eff}} = C_f - C_{\mathrm{fi}} C_i^{-1} C_{\mathrm{fi}}^T. \qquad (37)$$

The voltage $V_f$ can then be written as

$$\mathbf{V}_f = C_{\mathrm{eff}}^{-1} q_f - C_{\mathrm{eff}}^{-1} C_{\mathrm{fi}} C_i^{-1} q_i - C_{\mathrm{eff}}^{-1} (C_{\mathrm{fr}} - C_{\mathrm{fi}} C_i^{-1} C_{\mathrm{ri}}^T) V_r. \qquad (38)$$

Substituting eq. (38) into eq. (34),

$$q_r = C_{\mathrm{fr}}^T C_{\mathrm{eff}}^{-1} q_f - C_{\mathrm{fr}}^T C_{\mathrm{eff}}^{-1} C_{\mathrm{fi}} C_i^{-1} q_i + \left( C_r - C_{\mathrm{fr}}^T C_{\mathrm{eff}}^{-1} C_{\mathrm{fr}} + C_{\mathrm{fr}}^T C_{\mathrm{eff}}^{-1} C_{\mathrm{fi}} C_i^{-1} C_{\mathrm{ri}}^T \right) V_r. \qquad (39)$$

In a similar fashion, inserting eq. (38) into eq. (33) results in

$$\mathbf{V}_i = \left( C_i^{-1} + C_i^{-1} C_{\mathrm{fi}}^T C_{\mathrm{eff}}^{-1} C_{\mathrm{fi}} C_i^{-1} \right) q_i - C_i^{-1} C_{\mathrm{fi}}^T C_{\mathrm{eff}}^{-1} q_f + \left( C_i^{-1} C_{\mathrm{fi}}^T C_{\mathrm{eff}}^{-1} (C_{\mathrm{fr}} - C_{\mathrm{fi}} C_i^{-1} C_{\mathrm{ri}}^T) - C_i^{-1} C_{\mathrm{ri}}^T \right) V_r.$$

$$(40)$$

Using the above results, the electrostatic energy of the system can be written. Recall that

$$2E = q_i^T V_i + q_r^T V_r + q_f^T V_f. \qquad (41)$$

The eq. (41) can be written in charge space. Using eqs. (38) and (40), eq. (41) becomes

$$2E = q_f^T C_{\mathrm{eff}}^{-1} q_f + q_f^T C_{\mathrm{eff}}^{-1} C_{\mathrm{fi}} C_i^{-1} \left( C_{\mathrm{ri}}^T V_r - 2q_i \right) + V_r^T \left( C_r - C_{\mathrm{fr}}^T C_{\mathrm{eff}}^{-1} C_{\mathrm{fr}} + C_{\mathrm{ri}} C_i^{-1} C_{\mathrm{fi}}^T C_{\mathrm{eff}}^{-1} C_{\mathrm{fr}} \right) V_r$$

$$+ q_i^T \left( C_i^{-1} + C_i^{-1} C_{\mathrm{fi}}^T C_{\mathrm{eff}}^{-1} C_{\mathrm{fi}} C_i^{-1} \right) q_i - q_i^T \left( C_i^{-1} C_{\mathrm{ri}}^T + C_i^{-1} C_{\mathrm{fi}}^T C_{\mathrm{eff}}^{-1} C_{\mathrm{fi}} C_i^{-1} C_{\mathrm{ri}}^T \right) V_r. \qquad (42)$$

From the second term in eq. (42) the island charge, as well as the mutual capacitance matrix between regulated and island charge nodes, shifts the minima of the charge space energy landscape. The covariance of the charge distribution is given by C. The last three terms in eq. (42) do not depend on the state of the system $q_f$ and can thus be treated as constant.

Next the electrostatic energy can be written in voltage space. In doing so, the charge can first be written $q_f$ as

$$q_f = C_{\mathrm{eff}} V_f + \left( C_{\mathrm{fr}} - C_{\mathrm{fi}} C_i^{-1} C_{\mathrm{ri}}^T \right) V_r + C_{\mathrm{fi}} C_i^{-1} q_i. \qquad (43)$$

Using eqs. (33), (34) and (43) the electrostatic energy can be written as

$$2E = V_f^T C_{\mathrm{eff}} V_f + V_f^T \left( 2C_{\mathrm{fr}} - C_{\mathrm{fi}} C_i^{-1} C_{\mathrm{ri}}^T \right) V_r + q_i^T C_i^{-1} q_i + V_r^T C_r V_r$$

$$- q_i^T C_i^{-1} C_{\mathrm{ri}}^T V_r + V_i^T C_{\mathrm{ri}}^T V_r. \qquad (44)$$

From eq. (44) that the energy as a function of the regulated voltage $V_r$ does not depend on the island charge $q_i$ (the term

$q_i^T C_i^{-1} q_i$ is a constant). Due to the term $V_f^T C_{\text{eff}} V_f$ in eq. (44), in voltage space, the covariance matrix of the energy function when used in the Boltzmann distribution is given by $C_{\text{eff}}^{-1}$ instead of $C_{\text{eff}}$ when expressing $E$ in charge space (see the term $q_f^T C_{\text{eff}}^{-1} q_f$ $q_f$ in eq. (42)).

When adding $t$-gate shorting devices to a circuit, such devices can connect the charge islands to the rest of the circuit such that they become normal free nodes. The collective system has capacitance matrix given by

$$C_s = \begin{bmatrix} C_f & C_{\text{fi}} \\ C_{\text{fi}}^T & C_i \end{bmatrix}. \tag{45}$$

The charge covariance matrix of the original free nodes in this case is then $C_f$, which is different than the charge covariance matrix in the open case. Taking the inverse of the shorted capacitance matrix $C_s$,

$$C_s^{-1} = \begin{bmatrix} C_{\text{eff}}^{-1} & -C_{\text{eff}}^{-1} C_{\text{fi}} C_i^{-1} \\ -C_i^{-1} C_{\text{fi}}^T C^{-1} C_i^{-1} & C_i^{-1} C_{\text{fi}}^T C^{-1} C_{\text{fi}} C_i^{-1} \end{bmatrix}. \tag{46}$$

As can be seen from eq. (46), the voltage covariance of the relevant degrees of freedom is identical to the shorted case. As such, a programmable sampling device cannot be built in voltage space using only conservative components.

Given a circuit containing $N$ capacitors in parallel, each capacitor connected to a switch (for instance, the circuit in FIG. 6B has $N = 3$), the values of the capacitances $\{C_1, C_2, \cdots, C_N\}$ can be chosen to obtain the largest dynamic range of values for $C = \Sigma_j \alpha_j C_j$ where $\alpha_j$ is 1 if the $i$'th switch is a short and zero otherwise. To obtain the maximal dynamic range of values for $C$, $\{C_1, C_2, \cdots, C_N\}$ can be set to equal $\{1, 2, 4, \cdots, 2^{N-1}\}$. This relation results in the largest dynamic range of $C$ because of: (1) Uniqueness: Each subset of $\{1, 2, 4, \ldots, 2^{N-1}\}$ corresponds uniquely to a binary number of $N$ bits, ensuring all sums are distinct. (2) Maximal span: The sum ranges from 0 to $2^N - 1$ making the span as large as possible for any set of $N$ numbers.

Since the circuit in FIG. 6B is effectively closed, measuring the charge state $m$ of closed circuits built from the tunable capacitor circuit would generate samples from the Gaussian distribution in eq. (20) with covariance matrix $C^{-1}(t)$, which can be made time dependent by tuning the voltages to effectively change the capacitance of the circuit. As previously demonstrated, the charge space electrostatic energy of the system composed of regulated nodes, free nodes, and island nodes can be written

$$2E = q_f^T C_{\text{eff}}^{-1} q_f + q_f^T C_{\text{eff}}^{-1} C_{\text{fi}} C_i^{-1} \left( C_{\text{ri}}^T V_r - 2q_i \right) + V_r^T \left( C_r - C_{\text{fr}}^T C_{\text{eff}}^{-1} C_{\text{fr}} + C_{\text{ri}} C_i^{-1} C_{\text{fi}}^T C_{\text{eff}}^{-1} C_{\text{fr}} \right) V_r$$

$$+ q_i^T \left( C_i^{-1} + C_i^{-1} C_{\text{fi}}^T C_{\text{eff}}^{-1} C_{\text{fi}} C_i^{-1} \right) q_i - q_i^T \left( C_i^{-1} C_{\text{ri}}^T + C_i^{-1} C_{\text{fi}}^T C_{\text{eff}}^{-1} C_{\text{fi}} C_i^{-1} C_{\text{ri}}^T \right) V_r, \tag{47}$$

where $q_f$ and $q_i$ are the free and island charge vectors, $C_r$ and $C_i$ are the capacitances between regulated nodes and island nodes respectively. In eq. (47), $V_r$ is the voltage vector at regulated nodes, $C_{\text{fr}}$ is the capacitance matrix between free and regulated nodes, $C_{\text{fi}}$ is the capacitance matrix between free and island nodes, $C_{\text{ri}}$ is the cpacitance matrix between regulated and island nodes, and $C_{\text{eff}}$ is the effective capacitance matrix given by

$$C_{\text{eff}} = C_f - C_{\text{fi}} C_i^{-1} C_{\text{fi}}^T. \tag{48}$$

From the term $q_f^T C_{\text{eff}}^{-1} C_{\text{fi}} C_i^{-1} \left( C_{\text{ri}}^T V_r - 2q_i \right)$ in eq. (47), the island charge can shift a minima associated with the charge space energy landscape. All other terms in eq. (47) do not depend on the state of the system $q_f$ and thus act as a constant. The electrostatic energy can be written in voltage space as

$$2E = V_f^T C_{\text{eff}} V_f + V_f^T \left( 2C_{\text{fr}} - C_{\text{fi}} C_i^{-1} C_{\text{ri}}^T \right) V_r + q_i^T C_i^{-1} q_i + V_r^T C_r V_r$$

$$- q_i^T C_i^{-1} C_{\text{ri}}^T V_r + V_i^T C_{\text{ri}}^T V_r. \tag{49}$$

For a tunable capacitance circuit such as the one depicted in FIG. 5B, eq. (20) shows that the potential energy term that appears in the Boltzmann distribution at equilibrium is given by

$$\phi = e^2 \tfrac{1}{2} m^T C_{\text{eff}}^{-1} m = \tfrac{1}{2} q_f^T C_{\text{eff}}^{-1} q_f = \tfrac{1}{2} V_f^T C_{\text{eff}} V_f$$

with $C_{\text{eff}}$ given in eq. (48). By tuning the resistance by adjusting the voltage $V_g$, charge can flow off the islands, allowing the tuning of the effective capacitance matrix $C_{\text{eff}}$ as expected.

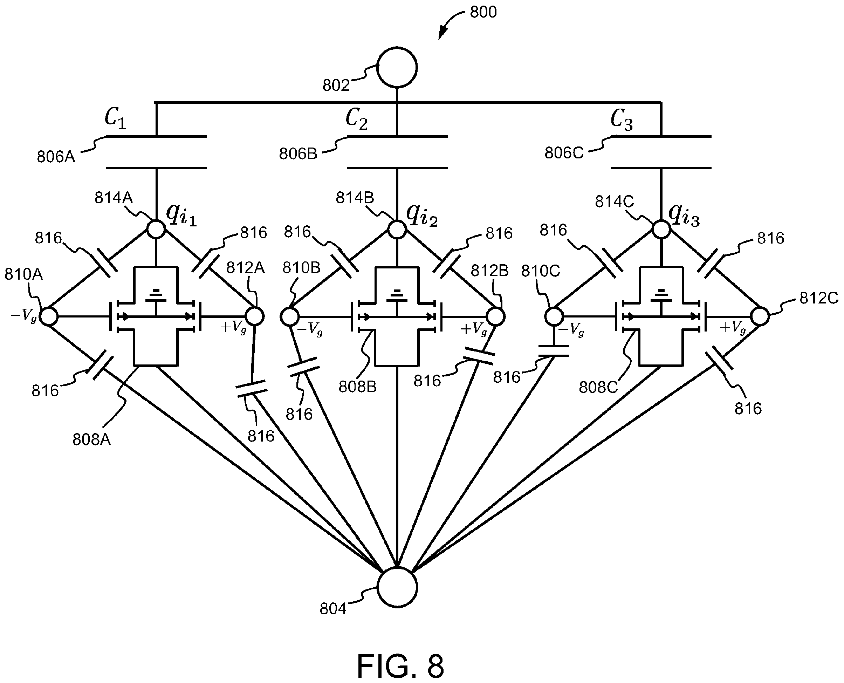

Some tunable capacitance circuits can comprise island charges and transistors that are associated with intrinsic capacitances. FIG. 8 depicts an example circuit 800 comprising a first node 802 and a second node 804 between which a capacitor 806A, a capacitor 806B, and a capacitor 806C are connected in parallel. Each of the capacitor 806A, the capacitor 806B, and the capacitor 806C is associated with respective capacitance $C_1$, $C_2$, $C_3$. In some examples, the circuit 800 can be referred to as a tunable capacitance circuit. Each of the capacitor 806A, the capacitor 806B, and the capacitor 806C is connected in series to a transistor circuit 808A, a transistor circuit 808B, a transistor circuit 808C, respectively. Each of the transistor circuit 808A, the transistor circuit 808B, the transistor circuit 808C comprises an nMOS and a pMOS transistor. The transistor circuit 808A, the transistor circuit 808B, and the transistor circuit 808C each have a node 810A, a node 810B, and a node 810C, respectively, associated with a negative voltage $-V_g$ and a node 812A, a node 812B, and a node 812C, respectively associated with a positive voltage $V_g$. Each of the transistor circuit 808A, the transistor circuit 808B, and the transistor circuit 808C also has an island node 814A, an island node 814B, and an island node 814C, respectively. Each of the island node 814A, the island node 814B, and the island node 814C is associated with a respective island charge $q_{i_1}$, $q_{i_2}$ and $q_{i_3}$. Capacitors 816 are distributed throughout circuit 800. Since the circuit 800 is effectively closed and eq. (20) is a Gaussian distribution, the circuit 800 in FIG. 8 can allow the sampling of charge vector $m$ of the free nodes from a Gaussian distribution with covariance matrix $C_{\text{eff}}$ given in eq. (48). Additionally, as mentioned above, the term $q_f^T C_{\text{eff}}^{-1} C_{\text{fi}} C_i^{-1} \left( C_{\text{ri}}^T V_r - 2q_i \right)$ in eq. (47) creates shifts in the minima of the energy landscape due to island charges.

A Maxwell capacitance matrix is: (1) Symmetric (2) Positive definite (3) Diagonally dominant: The self-capacitance terms can shift the diagonal elements by an arbitrary positive amount. The diagonal terms in the k'th row is given by $\sum_{j=1}^{n} C_{kj}$ (see eq. (50)) with $C_{kj}$ being the mutual capacitances between nodes $k$ and $j$ (when $k \neq j$) and $C_{kk}$ the self-capacitance. (4) Has off-diagonal terms that are either zero or negative.

The positive semi-definite and symmetric properties are also features of any covariance matrix used to sample from a Gaussian distribution. Regarding diagonal dominance, as previously described, the Maxwell Capacitance matrix for a circuit with n nodes can be written as

$$\begin{bmatrix} \sum_{j=1}^{n} C_{1j} & -C_{12} & \cdots & -C_{1n} \\ -C_{21} & \sum_{j=1}^{n} C_{2j} & \cdots & -C_{2n} \\ \cdots & \cdots & \cdots & \cdots \\ -C_{n1} & -C_{n2} & \cdots & \sum_{j=1}^{n} C_{nj} \end{bmatrix}. \tag{50}$$

In the diagonal terms (say for the $j$'th row of the capacitance matrix), $C_{jj}$ is the self-capacitance term which is the capacitance between the $j$'th free node and a distant ground. The self-capacitance term measures how much charge the node can store at a given voltage relative to this ground. The self-capacitance $C_{jj}$ is often greater than or equal to the sum of the magnitudes of the off-diagonal elements in that row, which reflects the fact that the nodes self-capacitance is often greater than the mutual capacitances with other nodes. Importantly, eq. (50) shows that the diagonal terms are shifted by a positive amount given by the self-capacitance.

For a system with state $v_f$, a general Gaussian distribution describing the voltage fluctuations has a probability density function given by

$$p(v_f) = \frac{1}{(2\pi)^{n/2}|\Sigma|^{1/2}} \exp\left(-\frac{1}{2}(v_f - \mu)^T \Sigma^{-1}(v_f - \mu)\right). \tag{51}$$

Expanding the exponent in eq. (51) and comparing it with the electrostatic energy in eq. (47), the covariance matrix $\Sigma$ and mean vector $\mu$ in voltage space are related to the capacitance and island charges by

$$\Sigma^{-1} \sim C_{\text{eff}} \tag{52}$$

$$\Sigma^{-1}\mu \sim \left(C_{\text{fi}}C_i^{-1}C_{\text{ri}}^T - 2C_{\text{fr}}\right)V_r, \tag{53}$$

so that

$$\Sigma \sim C_{\text{eff}}^{-1} \tag{54}$$

$$\mu \sim C_{\text{eff}}^{-1}\left(C_{\text{fi}}C_i^{-1}C_{\text{ri}}^T - 2C_{\text{fr}}\right)V_r, \tag{55}$$

where $C_{\text{eff}}$ is given by eq. (48). Although circuits with t-gate switches allow the tuning of $C_{\text{eff}}$, since $C_{\text{eff}}$ can take on only discrete values, $C_{\text{eff}}$ may not match exactly the desired $\Sigma^{-1}$. As discussed later, various trivial linear algebra transformations can be performed whenever there are discrepancies.

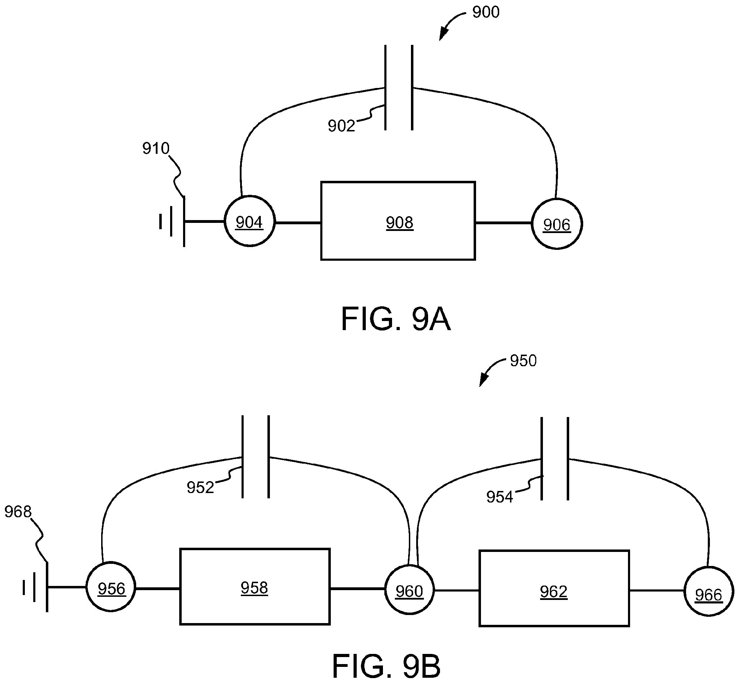

As previously discussed, a t-gate can comprise either a nMOS transistor (when $V_g$ - $V_S$ > $V_T$) or pMOS transistor (when $V_g$ - $V_S$ < - $|V_T|$) or a combination thereof. Some t-gate circuits can be associated with a thermal equilibrium time. FIGS. 9A and 9B depict example t-gate circuits. FIG. 9A depicts an example t-gate circuit 900 comprising a capacitor 902, a node 904, a t-gate 908, and a node 906. The node 904 is connected to ground 910 while the node 906 is free. FIG. 9B depicts an example t-gate circuit 950 comprising a first capacitor 952, a second capacitor 954, a node 956, a node 960, a node 966, a t-gate 958 and a t-gate 962. The node 956 is connected to a ground 968 while the node 960 and the node 966 are free. In FIG. 9A and FIG. 9B, the t-gate can be a nMOS transistor, such as the ones depicted in FIG. 5A and FIG¿ 5C, a pMOS transistor such as the ones depicted in FIG. 5B and FIG. 5D, or a combination thereof, such as the circuits depicted in FIG. 6A.

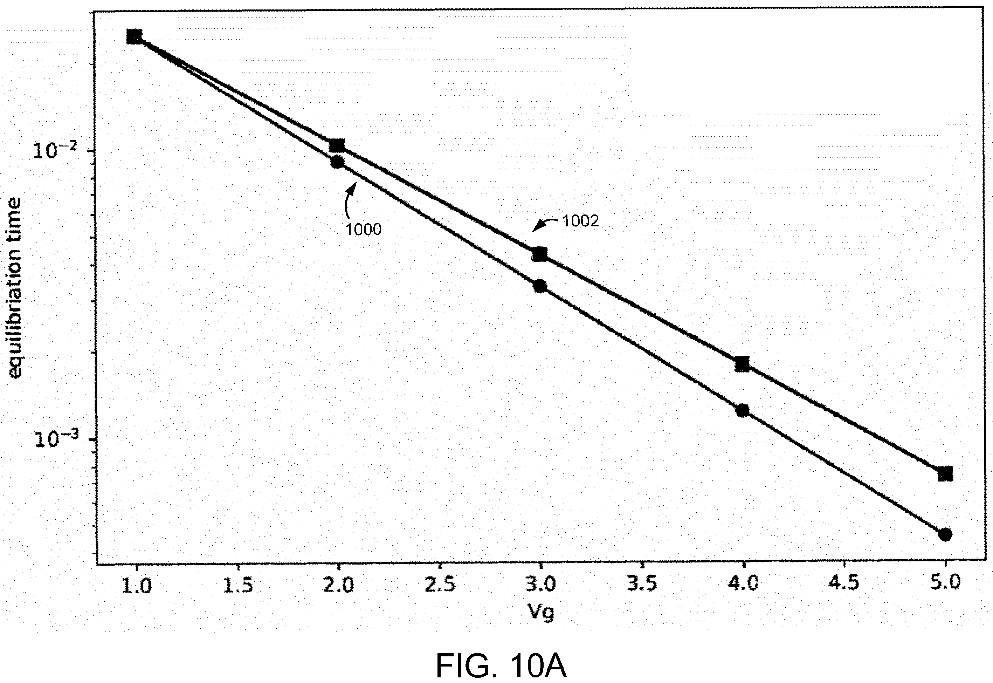

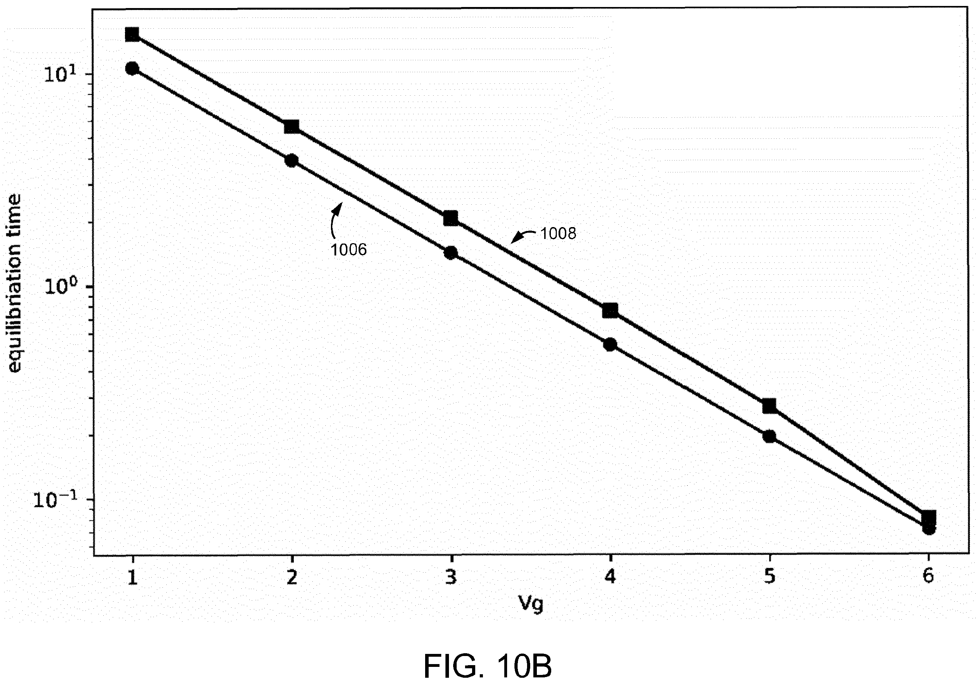

FIG. 10A depicts a plot of numerical simulations of thermal equilibrium times associated with the t-gate circuit 900 in FIG. 9A. The curve 1000 corresponds to a circuit comprising a t-gates such as the circuit depicted in FIG. 6A while the curve 1002 corresponds to a circuit comprising a the t-gates comprising an nMOS switch or a pMOS switch such as those depicted in FIGS. 5A-5D. FIG. 10B depicts a plot of numerical simulations of thermal equilibrium times associated with the t-gate circuit 950 in FIG. 9B. The curve 1006 corresponds to a circuit comprising a t-gates such as the circuit depicted in FIG. 6A while the curve 1008 corresponds to a circuit comprising a the t-gates comprising an nMOS switch or a pMOS switch such as those depicted in FIGS. 5A-5D. As shown in FIGS. 10A-10B, the thermal equilibrium time of the circuit depicted in FIG. 6A is lower than that of the nMOS and pMOS switches. However the difference in thermal equilibrium times is fairly minor. In addition, pMOS and nMOS devices can have nearly identical thermal equilibrium times. For these plots, the gate voltage for the pMOS device is - $V_g$ and the gate voltage for the nMOS device is + $V_g$.

To obtain the plots of thermal equilibrium times of the devices considered in FIGS. 10A-10B, the smallest non-zero eigenvalues for the steady state equation

$$\mathcal{L}(U_{\text{in}})p(m,t) = 0, \tag{56}$$

are numerically obtained. In the steady state equation, the linear operator $\mathcal{L}(U_{\text{in}})$ is given in eq. (13). If $\lambda_1$ is the smallest non-zero eigenvalue of $\mathcal{L}$, the thermal equilibrium time of the free nodes $\tau_{\text{thermal}}$ is given by $\tau_{\text{thermal}} = 1/\lambda_1$.

A capacitance matrix associated with a circuit can be tuned by controlling the flow of charges on or off of a charge island node using t-gate switches. Such manipulations can be performed to tune the effective capacitance matrix in eq. (48) such that the matrix more closely approximates or matches some target covariance matrix $\Sigma$ used in a Gaussian distribution of interest. More details on trivial linear algebra transformations that can be performed to map $C_{\text{eff}}$ to $\Sigma$ are discussed later.

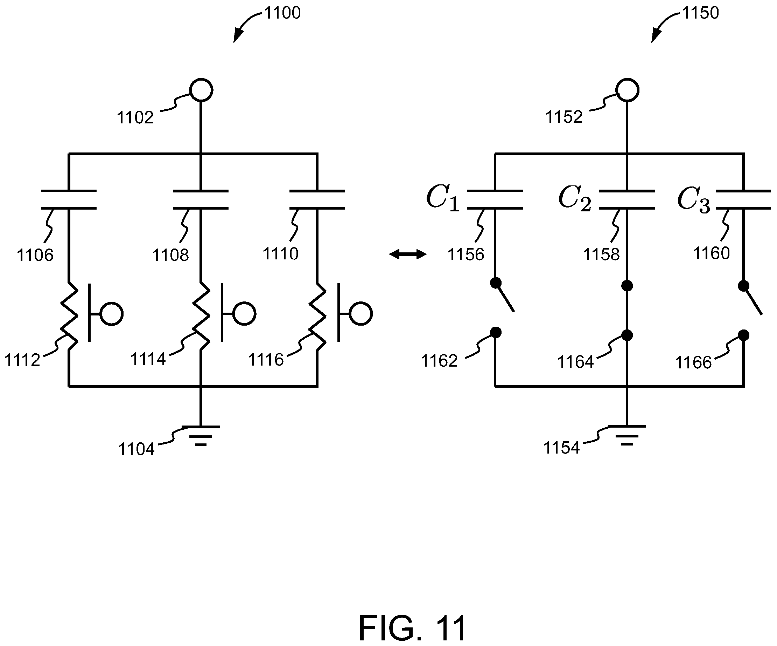

FIG. 11 depicts an example circuit 1100 comprising a first node 1102 and a ground node 1104. The circuit 1100 comprises a capacitor 1106, a capacitor 1108, and a capacitor 1110 that are connected in parallel. Each of the capacitor 1106, the capacitor 1108, and the capacitor 1110 is connected in series with a *t*-gate switch 1112, a *t*-gate switch 1114, and a *t*-gate switch 1116, respectively. The presence of the *t*-gate switch 1112, the t-gate switch 1114, the *t*-gate switch 1116 results in three island nodes. If *t*-gate switches are tuned such that the *t*-gate switch 1112 and the *t*-gate switch 1116 are open, the circuit 1100 behaves as circuit 1150 with open switch 1162, closed switch 1164, and open switch 1166. The circuit 1150 comprises a first node 1152 and a ground node 1154. The circuit 1150 comprises a capacitor 1156, a capacitor 1158, and a capacitor 1160 connected in parallel. Each of the capacitor 1156, the capacitor 1158, and the capacitor 1160 is associated with a respective capacitance $C_1$, $C_2$, $C_3$. The effective capacitance for circuit 1150 is $C_2$.

In a more general case of tuning the capacitance matrix associated with circuit 1100, the capacitor 1106, the capacitor 1108, and the capacitor 1110 can each be associated with a capacitance $C_1$, $C_2$, and $C_3$, respectively. The effective capacitance of the circuit 1100 can be written

$$C_{\text{eff}} = \sum_{j=1}^{3} \alpha(j) C_j, \tag{57}$$

where

$$\alpha(j) = \begin{cases} 0 & \text{if the } t\text{-gate is open,} \\ 1 & \text{otherwise.} \end{cases} \tag{58}$$

This equation follows from the fact that in the FIG. 11, the capacitors are connected in parallel and thus the total capacitance of the circuit is the sum of all capacitances when each t-gate is a short. When the *j*'th *t*-gate is open, the associated capacitor $C_j$ is disconnected from the circuit, effectively removing it. Thus, for a circuit containing *N* capacitors

$$C_{\text{eff}} = \sum_{j=1}^{N} \alpha(j) C_j. \tag{59}$$

Some circuits such as the example circuit 1100 can comprise a plurality of capacitors connected in parallel. In such capacitance circuits, each capacitor in the plurality of capacitors can have a different capacitance from any other capacitor in the capacitance circuit. In some capacitance circuits, each capacitor of a plurality of capacitors can have a capacitance that is twice a capacitance of at least another capacitor in the capacitance circuit.

In a general case of a circuit comprising multiple free nodes, the self and mutual capacitances of the circuit can be replaced with tunable capacitance circuit modules such as the circuit depicted in FIG. 11 but with *N* capacitors, as two distinct tunable capacitance circuits can have different numbers of capacitors. Since a *t*-gate can behave as a switch, each tunable capacitance circuit may be tuned to have a capacitance in the range 0 to $2^N - 1$ where *N* is the number of *t*-gates in a given tunable capacitance module. For instance, the off-diagonal term $-C_{ij}$ in eq. (50) may be tuned to be in the range 0 to $-(2^N - 1)$. The self-capacitances may also be tuned to be in the range 0 to $2^N - 1$. As such, the Maxwell capacitance matrix can be written as

$$C_{\text{eff}} = \begin{bmatrix} \sum_{j=1}^{n} C_{1j}^{(t)} & -C_{12}^{(t)} & \cdots & -C_{1n}^{(t)} \\ -C_{21}^{(t)} & \sum_{j=1}^{n} C_{2j}^{(t)} & \cdots & -C_{2n}^{(t)} \\ \cdots & \cdots & \cdots & \cdots \\ -C_{n1}^{(t)} & -C_{n2}^{(t)} & \cdots & \sum_{j=1}^{n} C_{nj}^{(t)} \end{bmatrix}, \tag{60}$$

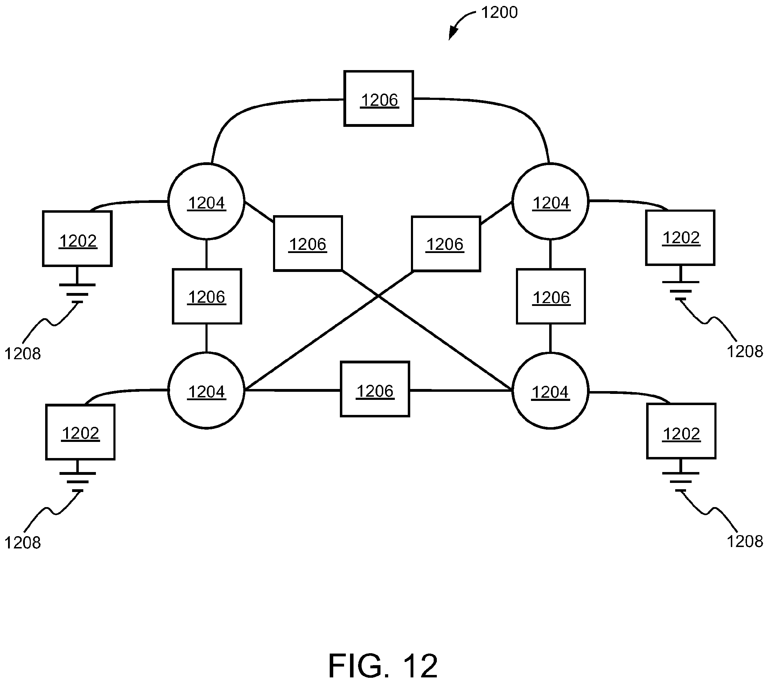

where the superscript *t* in $C_{ij}^{(t)}$ indicates that the capacitance $C_{ij}$ may be tuned to take a value in the range 0 to $2^N - 1$ depending on which t-gates are shorts or opened for the tunable capacitance circuit used between free nodes *i* and *j*. An example circuit comprising multiple nodes that are interconnected with each other by tunable capacitance circuits that can be used to tune a Maxwell capacitance matrix associated with the system is depicted in FIG. 12.

FIG. 12 depicts an example circuit 1200 comprising a tunable capacitance network consisting essentially of interconnected wires intersecting at a plurality of nodes formed by nodes 1204. Selected pairs of nodes 1204 are interconnected by a tunable capacitance circuit 1206 and one or more of the nodes 1204 are connected to the common ground 1208 by a tunable capacitance circuit 1202. In other words, the circuit 1200 comprises a plurality of tunable capacitance circuits formed by the tunable capacitance circuits 1202 and the tunable capacitance circuits 1206. A circuit 1200 can also comprise one or more voltage sources (not pictured) configured to provide respective voltages relative to a common ground. Each tunable capacitance circuit 1202 and each tunable capacitance circuit 1206 can comprise a circuit configuration similar to the circuit depicted in FIG. 6B, wherein a plurality of switchable capacitors are connected in parallel, and each switchable capacitor of a plurality of the switchable capacitors comprises an active switching element connected in series with a corresponding capacitor. Each active switching element of each switchable capacitor of each plurality of the switchable capacitors can comprise an nMOS transistor such as depicted in FIG. 5A and FIG. 5C, a pMOS transistor such as depicted in FIG. 5B and FIG. 5D, or some combination thereof such as depicted in FIG. 6A and FIG. 6B. In other words, each active switching element comprises a transistor having three or more terminals including at least a first terminal connected to a first voltage source of the one or more voltage sources and a second terminal and a third terminal, wherein the second terminal and third terminal are configured to connect a corresponding capacitor to the tunable capacitance network in a closed switch state and to disconnect the corresponding capacitor from the tunable capacitance network in an open switch state. In some implementations, the first voltage source can be configured to provide a voltage that is lower than a threshold voltage of the transistor.

In some implementations, external circuitry can be configured to interact with a circuit architecture or a circuit, or portions thereof. Some implementations of external circuitry can interact with a circuit architecture by applying voltages to or reading voltages from a circuit architecture or portions thereof. For instance, control circuitry can be configured to apply control signals or generate voltages to be applied to a circuit. In some examples, readout circuitry configured to read, sample, and/or store voltages from a circuit. Some implementations of readout circuitry can comprise at least one voltage sampling circuit connected to a corresponding node of the tunable capacitance network such that the voltage sampling circuit is configured to record one or more voltage samples. In such implementations, a measurement can be performed wherein all closed active switching elements in switchable capacitors in a first tunable capacitance circuit of the plurality of tunable capacitance circuits are in a closed switch state during recording of at least one of the voltages samples. In some examples, the closed switching elements can be configured to: individually dissipate power by a resistance between the second and third terminals of the closed active switching element larger than resistances over any of the wires that connect any of the tunable capacitance circuits to any node in the tunable capacitance network, and collectively provide an effective capacitance of the first tunable capacitance circuit that is substantially equal to a sum of capacitances of all capacitors connected to the closed active switching elements.

In some implementations, circuitry configured to apply control signals to a circuit architecture, or portions thereof, can be positioned on a separate integrated circuit chip or device as the circuit architecture. In some examples, control signals applied to a circuit or signals produced by a circuit can be weak. In some implementations, to mitigate weak signals, circuitry configured to apply control signals to a circuit architecture, or portions thereof, can be positioned in proximity to the circuit architecture, i.e., on the same integrated circuit chip or device that comprises the circuit architecture. In some implementations, circuitry configured to readout signals from a circuit architecture, or portions thereof, can be positioned in proximity to the circuit architecture, i.e., on the same integrated circuit chip or device that comprises the circuit architecture. Positioning one or both of the readout circuitry or the control circuitry in proximity to a circuit architecture can be useful to mitigate losses associated with transmitting weak signals over larger distances.

The effective capacitance matrix $C_{\text{eff}}$ given in eq. (60) can identically be obtained from eq. (48) when considering island charges. For convenience, eq. (48) is reproduced

$$C_{\text{eff}} = C_f - C_{\text{fi}} C_i^{-1} C_{\text{fi}}^T. \tag{61}$$

In eq. (61), $C_f$ is the standard Maxwell capacitance matrix when all t-gates are shorts since in this case there are no island charges.

Without intending to be bound by theory, the following is an example of a theoretical model for illustrating features. Let $C_f$ be an $M \times M$ matrix. Suppose all $t$-gate circuits are short except for one in the tunable capacitance circuit for the capacitor $C_{ij}^{(t)}$. In this case a charge island is created (say with capacitance $C_{ij}^{(1)}$). Now $C_i^{-1} = 1/C_{ij}^{(1)}$ and the $M \times 1$ matrix $C_{\text{fi}}$ can non-zero elements given by $C_{ij}^{(1)}$ in rows $i$ and $j$. The product $C_{\text{fi}} C_i^{-1} C_{\text{fi}}^T$ can be an $M \times M$ matrix which is non-zero only in row $i$ and column $j$ with value $C_{ij}^{(1)}$ . As such, the row $i$ and column $j$ of $C_f$ can be reduced by $C_{ij}^{(1)}$ .

In general, if there are $k$ open $t$-gates, a circuit can contain $k$ charge islands. The matrix $C_i^{-1} = \mathrm{diag}(1/C_1, \cdots, 1/C_k)$ (where for notational simplicity, the $j$'th charge island is assumed to have capacitance $C_j$). The matrix $C_{\mathrm{fi}}$ can be $M \times k$ with a non-zero entry in row $i$ and column $t$ if the $i$'th free node has a mutual capacitance with the $t$'th island charge (and if non-zero, it can have capacitance $C_t$). Performing the multiplication $C_{\mathrm{int}} = C_i^{-1} C_{\mathrm{fi}}^T$ results in a $k \times M$ matrix which is 1 if in row $s$ and column $t$ if there is an mutual capacitance between island charge $s$ and free node $t$. Otherwise the element of $C_{\mathrm{int}}$ is zero. Performing the multiplication $C_{\mathrm{fi}} C_{\mathrm{int}}$ results in an $M \times M$ matrix where the row $i$ and column $j$ is $\sum_t C_t^{(ij)}$ where $C_t^{(ij)}$ is a capacitance between an island charge and free nodes $i$ and $j$. As such, $C_{\mathrm{fi}} C_i^{-1} C_{\mathrm{fi}}^T$ can reduce the capacitance of row $i$ and column $j$ $C_f$ by $\sum_t C_t^{(ij)}$ which is equivalent to the added island charges with mutual capacitances between free nodes $i$ and $j$.

The effective capacitance matrix associated with tunable capacitance circuits can be written as

$$C_{\mathrm{eff}} = \begin{bmatrix} \sum_{j=1}^n C_{1j}^{(t)} & -C_{12}^{(t)} & \cdots & -C_{1n}^{(t)} \\ -C_{21}^{(t)} & \sum_{j=1}^n C_{2j}^{(t)} & \cdots & -C_{2n}^{(t)} \\ \cdots & \cdots & \cdots & \cdots \\ -C_{n1}^{(t)} & -C_{n2}^{(t)} & \cdots & \sum_{j=1}^n C_{nj}^{(t)} \end{bmatrix}, \tag{62}$$

where $C_{ij}^{(t)}$ indicates that the capacitance $C_{ij}$ may be tuned to take a value in the range 0 to $2^N$ - 1 depending on which $t$-gates are shorts or opened for the tunable capacitance circuit used between free nodes $i$ and $j$ (assuming there are $N$ capacitors in parallel in the tunable capacitance circuit for $C_{ij}$). As can be seen from eq. (62), such transformations cannot make the off-diagonal terms of $C_{\mathrm{eff}}$ positive (since such terms are shifted by negative values). Further, the diagonal terms are also shifted by negative values.

Families of covariance matrices $\Sigma$ can be mapped to the family of matrices given by $C_{\mathrm{eff}}^{-1}$ through the use of trivial linear algebra transformations. A more restrictive case is introduced and then a more general case is considered. In what follows, $C_{\mathrm{eff}}^{-1}$ is used instead of $C_{\mathrm{eff}}$ due to the relationship in eq. (54). The Maxwell Capacitance matrices are positive definite, which means that the inverse matrices are also positive definite.

Case 1: Let $\Sigma$ be the covariance matrix of some Gaussian distribution from which to sample, and let $C_{\mathrm{eff}}$ be obtained from eq. (48) for some closed circuit comprising a $t$-gate switch. Suppose the off-diagonal elements of $\Sigma$ satisfy $\Sigma_{ij} \leq 0$ for all $i \neq j$. Suppose further that using eq. (62), there exists a choice of elements of $C_{\mathrm{fi}}$ in eq. (48) such that $(C_{\mathrm{eff}}^{(ij)})^{-1} = \Sigma_{ij}$, where $(C_{\mathrm{eff}}^{(ij)})^{-1}$ 1 is the element of $C_{\mathrm{eff}}^{-1}$ in the $i$'th row and $j$'th column. In this setting, $C_{\mathrm{eff}}^{-1}$ and $\Sigma$ differ in their diagonal elements. The difference is assumed to arise from a constant shift across all rows, i.e.

$$C_{\mathrm{eff}}^{-1} = \Sigma + \sigma I \tag{63}$$

for some constant $\sigma \in \mathbb{R}$. In this case, both $\Sigma$ and $C_{\mathrm{eff}}^{-1}$ have the same eigenvectors, and the eigenvalues $\lambda_\Sigma$ of $\Sigma$ are related to the eigenvalues $\lambda_{C_{\mathrm{eff}}}$ by $\lambda_{C_{\mathrm{eff}}} = \lambda_\Sigma + \sigma$. Samples from the distribution $\mathcal{N}(\mu, \Sigma)$ can be reconstructed given samples from $\mathcal{N}(\mu, C_{\mathrm{eff}})$ when eq. (63) is satisfied.

Now let $U$ be the matrix of eigenvectors for $\Sigma$ and $C_{\mathrm{eff}}^{-1}$ (which is othonormal since $\Sigma$ and $C_{\mathrm{eff}}^{-1}$ is positive-definite and symmetric). Also let A be the diagonal matrix of eigenvalues of $\Sigma$. $\Sigma$ and $C_{\text{eff}}^{-1}$ can be written as

$$\Sigma = U\Lambda U^T, \tag{64}$$

$$C_{\text{eff}}^{-1} = U(\Lambda + \sigma I)U^T. \tag{65}$$

Suppose a sample $X' \sim \mathcal{N}(\mu, C_{\text{eff}}^{-1})$ needs to be transformed into a sample $X \sim \mathcal{N}(\mu, \Sigma)$. A centered random variable can be defined $Y' = X' - \mu \sim \mathcal{N}(0, C_{\text{eff}}^{-1})$ and $\Lambda' = A + \sigma I$. $Y'$ can be written as

$$Y' = U(\Lambda')^{1/2}Z$$
$$= U(\Lambda + \sigma I)^{1/2}Z, \tag{66}$$

where $Z \sim \mathcal{N}(0, I)$. The result in eq. (66) follows from the fact that $\mathbb{E}[Y'] = U(\Lambda')^{1/2}\mathbb{E}[Z] = 0$ and

$$\text{Var}[Y'] = U(\Lambda')^{1/2}\text{Var}[Z]((\Lambda')^{1/2})^T U^T$$
$$= U\Lambda'U^T = C_{\text{eff}}^{-1}. \tag{67}$$

From eq. (66), Z can be written

$$Z = \Lambda'^{-1/2}U^T Y', \tag{68}$$

where $\Lambda'^{-1/2}$ is just the element-wise inverse square root of the eigenvalues of $C_{\text{eff}}^{-1}$. Defining $Y = X - \mu$, $X$ is

$$X = \mu + U\Lambda^{1/2}Z \tag{69}$$

where Z is computed from eq. (68). The matrix $U$ requires knowledge of all the eigenvectors of $C_{\text{eff}}^{-1}$. Having to diagonalize $C_{\text{eff}}^{-1}$ to compute $U$ may be undesired due to the computational costs. However since $C_{\text{eff}}^{-1}$ can only take on a finite set of values (which are known based on the capacitances at fabrication time of the chip), the eigenvectors for each possible combination of $C_{\text{eff}}^{-1}$ can be pre-computed, and based on the choice of $V_g$ for each $t$-gate circuit or tunable capacitance circuit, the $U$ matrix would be known.

Case 2: The following analysis can apply to any symmetric positive definite matrices (and thus to $C_{\text{eff}}^{-1}$ and $\Sigma$). The following eigenvalue decomposition can be performed

$$C_{\text{eff}}^{-1} = U_e\Lambda_e U_e^T \tag{70}$$

$$\Sigma = U_s\Lambda_s U_s^T, \tag{71}$$

where $U_e$ and $U_s$ are orthogonal matrices whose columns are the eigenvectors of $C_{\text{eff}}^{-1}$ and $\Sigma$. Further, the matrices $\Lambda_e$ and $\Lambda_s$ are diagonal matrices whose diagonal elements are eigenvalues of $C_{\text{eff}}^{-1}$ and $\Sigma$.

Let $X' \sim \mathcal{N}(\mu, C_{\text{eff}}^{-1})$. $Y'$ can be defined as $Y' = X' - \mu$. The samples $Y'$ can be transformed to the standard normal space using eigenvalues and eigenvectors of $C_{\text{eff}}^{-1}$ as

$$Z = \Lambda_e^{-1/2} U_e^T Y', \tag{72}$$

where $Z \sim \mathcal{N}(0, I)$. Next, the standarized samples $Z$ can be scaled to match the covariance matrix of $\Sigma$

$$Y = U_s \Lambda_s^{1/2} Z, \tag{73}$$

upon which $X = \mu + Y \sim \mathcal{N}(\mu, \Sigma)$.

Case 3: Suppose that the off-diagonal elements of $C_{\text{eff}}^{-1}$ are identical to those of $\Sigma$ (as in Case 1). However, multiple *diagonal* elements of $C_{\text{eff}}^{-1}$ can differ from $\Sigma$. That is, $\Sigma$ can be written

$$\Sigma = C_{\text{eff}}^{-1} + \text{diag}(c_1, \cdots, c_n), \tag{74}$$

with $c_i \in \mathbb{R}$ for all $i \in \{1, \cdots, n\}$. $\text{diag}(c_1, \cdots, c_n)$ is assumed to act as a small perturbation of $C_{\text{eff}}^{-1}$. Let $\lambda_1, \lambda_2, \cdots, \lambda_n$ be the eigenvalues of $C_{\text{eff}}^{-1}$ and $v_1, \cdots, v_n$ be its eigenvectors, which as in Case 1 may be pre-computed since the range of values for $C_{\text{eff}}$ are finite. Since $C_{\text{eff}}^{-1}$ is symmetric and positive-definite, it can be written as

$$C_{\text{eff}}^{-1} = V \Lambda V^T \tag{75}$$

where $V$ is an orthonormal matrix whose columns are eigenvectors of $C_{\text{eff}}^{-1}$, and $\Lambda = \text{diag}(\lambda_1, \lambda_2, \cdots, \lambda_n)$ is the matrix of eigenvalues. $\Sigma$ can be written

$$\Sigma = C_{\text{eff}}^{-1} + D \tag{76}$$

where $D = \text{diag}(c_1, \cdots, c_n)$.

The first-order correction to the eigenvalues of $C_{\text{eff}}^{-1}$ due to $D$ is given by the Rayleigh quotient for the unperturbed eigenvectors. Given the eigenvector $v_i$ of $C_{\text{eff}}^{-1}$, the eigenvalue of $\Sigma$ can be approximated as

$$\lambda_i' \approx \lambda_i + v_i^T D v_i, \tag{77}$$

where it is assumed that the eigenvectors $v_i$ are normalized. The perturbed eigenvectors are given by

$$v_i' \approx v_i + \sum_{j \neq i} \frac{v_j^T D v_i}{\lambda_i - \lambda_j} v_j. \tag{78}$$

The steps in eqs. (77) and (78) can be iterated to obtain better approximations to the eigenvalues and eigenvectors of $\Sigma$. In other words, this process can comprise iteratively calculating one or more eigenvectors. With the approximate eigenvalues and eigenvectors of $\Sigma$ given in eqs. (77) and (78), the steps in Case 2 above can be repeated to obtain samples $X \sim \mathcal{N}(\mu, \Sigma)$ given samples $X' \sim \mathcal{N}(\mu, C_{\text{eff}}^{-1})$. Note that such computations can much more efficient than having to diagonalize $\Sigma$ as can be needed for instance in Case 2.

Without intending to be bound by theory, the following is an example of a theoretical model for deriving eq. (78). Consider two symmetric and positive-definite matrices $A$ and $B$, with

$$B = A + D \tag{79}$$

where $D$ is a diagonal matrix that acts as a small perturbation. Since $A$ is symmetric and positive-definite, its eigenvectors $\{v_1, v_2, \cdots, v_n\}$ form an orthonormal basis. The eigenvalues of $A$ can also be denoted by $\{\lambda_1, \lambda_2, \cdots, \lambda_n\}$. The Rayleigh quotient for a vector x with respect to the matrix $B$ can be defined as

$$\begin{aligned} R_B(x) &= \frac{x^T B x}{x^T x} \\ &= \frac{x^T A x}{x^T x} + \frac{x^T D x}{x^T x}. \end{aligned} \tag{80}$$

For the eigenvector $v_i$,

$$R_B(v_i) = \lambda_i + v_i^T D v_i, \tag{81}$$

where the fact that the vectors $\{v_1, v_2, \cdots, v_n\}$ are normalized was used. The approximate eigenvalues $\lambda_i'$ of $B$ are given by

$$\lambda_i' = \lambda_i + v_i^T D v_i. \tag{82}$$

Since $D$ is a small perturbation, the approximate eigenvectors of $B$ can be written to leading order as

$$v_i' \approx v_i + \delta v_i. \tag{83}$$

A goal can then be to compute the elements $\delta v_i$. Using eq. (79) and the fact that $A v_i = \lambda_i v_i$, the eigenvalue equation for $B$ can be written as

$$\begin{aligned} B(v_i + \delta v_i) &= (\lambda_i + v_i^T D v_i)(v_i + \delta v_i) \\ (A + D)(v_i + \delta v_i) &= \lambda_i v_i + \lambda_i \delta v_i + (v_i^T D v_i) v_i \\ \lambda_i v_i + A \delta v_i + D v_i &= \lambda_i v_i + \lambda_i \delta v_i + (v_i^T D v_i) v_i \\ A \delta v_i + D v_i &= \lambda_i \delta v_i + (\delta \lambda_i) v_i. \end{aligned} \tag{84}$$

Rearranging the terms in last line of eq. (84),

$$(A - \lambda_i I) \delta v_i = -D v_i + (v_i^T D v_i) v_i. \tag{85}$$

The perturbation $\delta v_i$ can be expressed as a sum of the eigenvectors of A as

$$\delta v_i = \sum_{j \neq i} c_{ij} v_i. \tag{86}$$

Inserting eq. (86) into eq. (85) and using the eigenvalue equation for A,

$$\sum_{j \neq i} c_{ij} (\lambda_j - \lambda_i) v_j = -D v_i + (v_i^T D v_i) v_i. \tag{87}$$

Multiplying eq. (87) to the left by $v_k$ (with $k \neq i$) and using the orthonormal properties of the eigenvectors,

$$c_{ik} (\lambda_k - \lambda_i) = -v_k^T D v_i, \tag{88}$$

so that

$$c_{ik} = -\frac{v_k^T D v_i}{\lambda_k - \lambda_i}. \tag{89}$$

Using eqs. (86) and (89), the approximate eigenvalues of B to leading order are given by

$$v_i' \approx v_i - \sum_{j \neq i} \left( \frac{v_j^T D v_i}{\lambda_j - \lambda_i} \right) v_j. \tag{90}$$

Using the updated eigenvectors, the steps leading to eq. (90) can be iterated to get better approximations for the eigenvalues and eigenvectors of $B$. In other words, this process can comprise iteratively calculating one or more eigenvectors.

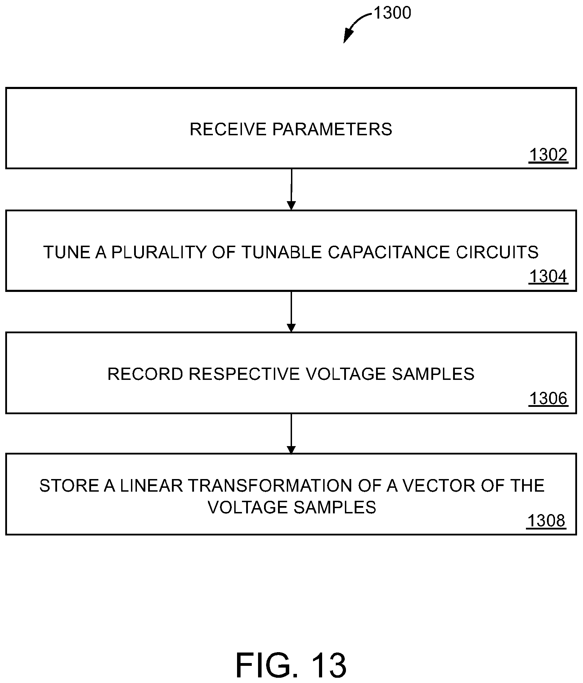

FIG. 13 depicts a flowchart 1300 containing an example method for configuring a circuit for generating samples from a target distribution. The method comprises receiving 1302 a matrix representing parameters associated with the target distribution, tuning 1304 a plurality of tunable capacitance circuits in a tunable capacitance network based at least in part on respective elements of the received matrix, wherein the tunable capacitance network consists essentially of interconnected wires intersecting at a plurality of nodes with selected pairs of the nodes interconnected by a respective tunable capacitance circuit and one or more of the nodes connected to a common ground by a respective tunable capacitance circuit, recording 1306 respective voltage samples from a plurality of nodes of the tunable capacitance network, and storing 1308 a linear transformation of a vector of the voltage samples based at least in part on the received matrix.

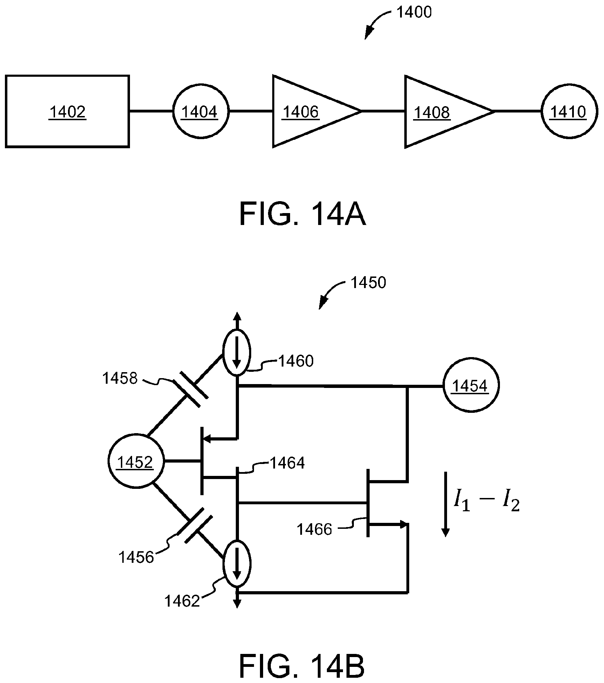

Some circuits that can sample a Gaussian distribution can incorporate a measurement circuit that can measure voltage fluctuations of the free nodes. Some measurement circuits can be non-destructive. Some circuits capable of performing non-destructive measurements can be configured such that the measurements do not alter a voltage sample that is being recorded by more than 1% during a particular non-destructive voltage measurement. FIG. 14A depicts an example circuit 1400 that can perform a non-destructive measurement of a voltage node 1404. The circuit 1400 contains a probabilistic circuit 1402, a sense amplifier 1406, a gain amplifier 1408, and an output node 1410. In some example circuits, the gain amplifier 1408 can be associated with a gain close to 0dB.

The input capacitance of a sense amplifier, sometimes referred to as a sense amp, can load the state of a free node being measured and in some implementations, can be destructive. As such, a small device can be used to act as the input state of the sense amplifier. This device makes the input capacitance in the same order or smaller than the probabilistic circuit whose output is the free node being measured and which drives the sense amplifier. FIG. 14B depicts an example circuit 1450 that can be utilized as a sense amplifier in circuit 1400. The circuit 1450 comprises a node 1452 associated with a voltage $V_{in}$ and a node 1454 associated with a voltage $V_{out}$. The circuit 1450 also comprises a capacitor 1456 associated with a capacitance $C_{gd}$, a capacitor 1458 associated with a capacitance $C_{gs}$, a current source 1460 associated with a current $I_1$, and a current source 1462 associated with a current $I_2$ The circuit 1450 also comprises a pnp transistor 1464 and an npn transistor 1466. A source-follower configuration with feedback as the buffer can also be used. The example circuit 1450 has two capacitances, namely $C_{gs}$ and $C_{gd}$ that load the state of the free node being measured. In a source-follower configuration, the input and output nodes are the same and the $C_{gs}$ capacitance is not seen by the input node. A capacitor can be seen as a load if it needs to be charged or discharged. If the voltage across the capacitor doesn't charge, then there is no charging or discharging and hence it is not loading which is what happens for $C_{gs}$ since the input and output of the sense amplifier are the same. This input and output can be similar when a gain is close to 0dB.

In some implementations, $C_{gd}$ is the only capacitance seen by the input node and can be half that of $C_{gs}$. Overall the measurement is non-destructive because the measurement can have minimal to no-impact on the free node that is being measured as the free node can be loaded with a very small capacitance.

In some implementations, a circuit architecture can be formed as part of a system. A system can be implemented in various configurations, including as a single apparatus or as a combination of one or more apparatuses that collectively perform the functions of a system. In some examples, the one or more apparatuses can form a device, i.e., a system-on-a-chip, or the one or more apparatuses can be separate devices.

In some implementations, a system can be formed from one or more integrated circuit (IC) chips comprising portions of a circuit architecture. Some circuit architectures can be distributed across multiple chips or consolidated onto a single chip. Some chips can comprise multiple layers of material. In some examples, portions of a circuit architecture can be formed across several layers of devices.

Some systems can comprise analog, digital, or mixed-signal circuitry configured to perform functions such as signal processing, voltage regulation, or data acquisition. Some systems can comprise interface or control circuitry configured to perform functions such as applying bias voltages, measuring voltages, or interfacing with components of the circuit. In some examples, control circuitry can be implemented in one or more dedicated regions of an IC, or distributed throughout a circuit architecture. In some examples, control circuitry can comprise components such as a field-programmable gate array (FPGA), an application specific integrated circuit (ASIC), one or more processors or processor cores, including central processing unit(s) (CPU(s)) and/or graphics processing unit(s) (GPU(s)), or other computing devices or modules capable of executing a program (e.g., software and/or firmware) comprising instructions or other compiled or executable code. The electronic circuitry can also include at least one data storage system (e.g., including volatile and non-volatile memory, and/or storage media). The program may be provided on a computer-readable storage medium, or delivered over a communication medium such as a wired or wireless network, to a device module where it can be stored and eventually executed when read by the device to perform the procedures of the program.

In some implementations, portions of a circuit architecture and control circuitry can be arranged in a flip-chip configuration to allow for three-dimensional integration of multiple chips or substrates. Some flip-chip configurations comprise conductive structure such as wire bonds, microbumps, or vias to facilitate electrical communication between multiple layers or chips.

While the disclosure has been described in connection with certain embodiments, it is to be understood that the disclosure is not to be limited to the disclosed embodiments but, on the contrary, is intended to cover various modifications and equivalent arrangements included within the scope of the appended claims, which scope is to be accorded the broadest interpretation so as to encompass all such modifications and equivalent structures as is permitted under the law.

**Claims**

1. A method for configuring a circuit for generating samples from a target distribution, the method comprising:

    receiving a matrix representing parameters associated with the target distribution;
    tuning a plurality of tunable capacitance circuits in a tunable capacitance network based at least in part on respective elements of the matrix, wherein the tunable capacitance network consists essentially of interconnected wires intersecting at a plurality of nodes with selected pairs of nodes of the plurality of nodes interconnected by a respective tunable capacitance circuit of the plurality of tunable capacitance circuits and one or more nodes of the plurality of nodes connected to a common ground by a respective tunable capacitance circuit of the plurality of tunable capacitance circuits;
    recording respective voltage samples from the plurality of nodes of the tunable capacitance network; and
    storing a linear transformation of a vector of the voltage samples based at least in part on the matrix.

2. The method of claim 1, wherein each tunable capacitance circuit of the plurality of tunable capacitance circuits in the tunable capacitance network comprises a plurality of switchable capacitors connected in parallel and each switchable capacitor of each plurality of switchable capacitors comprises an active switching element connected in series with a corresponding capacitor.

3. The method of claim 2, wherein each active switching element of each switchable capacitor of each plurality of switchable capacitors is a transistor comprising three or more terminals including at least a first terminal connected to a voltage source of one or more voltage sources and a second terminal and a third terminal, wherein the second terminal and the third terminal are configured to connect a corresponding capacitor to the tunable capacitance network in a closed switch state and to disconnect the corresponding capacitor from the tunable capacitance network in an open switch state.

4. The method of claim 3, wherein at least the first terminal of each active switching element of each switchable capacitor of each plurality of switchable capacitors is connected to the voltage source of the one or more voltage sources and the voltage source of the one or more voltage sources is configured to provide a voltage that is lower than a threshold voltage of the transistor.

5. The method of any one claims 1 to 4, wherein recording voltage samples is performed using one or more voltage sampling circuits configured to perform non-destructive voltage measurements.

6. The method of any one of claims 1 to 5, wherein the linear transformation is based at least in part on one or more eigenvalues and one or more eigenvectors associated with one or more capacitors in the plurality of tunable capacitance circuits.

7. The method of claim 6, wherein the linear transformation comprises transforming the vector of voltage samples based at least in part on the one or more eigenvalues and the one or more eigenvectors associated with one or more capacitors in the plurality of tunable capacitance circuits.

8. The method of claim 6, wherein the linear transformation comprises iteratively calculating one or more eigenvectors using the vector of voltage samples and one or more eigenvectors associated with one or more capacitors in the plurality of tunable capacitance circuits.

9. An apparatus comprising:

one or more voltage sources configured to provide respective voltages relative to a common ground;
a tunable capacitance network consisting essentially of interconnected wires intersecting at a plurality of nodes with selected pairs of nodes of the plurality of nodes interconnected by a respective tunable capacitance circuit of a plurality of tunable capacitance circuits and one or more nodes of the plurality of nodes connected to the common ground by a respective tunable capacitance circuit of the plurality of tunable capacitance circuits, wherein:

each tunable capacitance circuit of the plurality of tunable capacitance circuits comprises a plurality of switchable capacitors connected in parallel, and
each switchable capacitor of each plurality of switchable capacitors comprises an active switching element connected in series with a corresponding capacitor; and

at least one voltage sampling circuit connected to a corresponding node of the plurality of nodes of the tunable capacitance network configured to record one or more voltage samples.

10. The apparatus of claim 9, wherein a voltage sampling circuit of the at least one voltage sampling circuit comprises a sense amplifier and a gain amplifier and a voltage sampling circuit of the at least one voltage sampling circuit is configured to perform non-destructive voltage measurements that do not alter a voltage sample that is being recorded by more than 1% during a particular non-destructive voltage measurement.

11. The apparatus of claim 9 or 10, wherein each active switching element of a switchable capacitor of the plurality of switchable capacitors comprises three or more terminals including at least a first terminal connected to one voltage source of the one or more voltage sources and a second terminal and a third terminal, wherein the second terminal and the third terminal are configured to connect a corresponding capacitor to the tunable capacitance network in a closed switch state and to disconnect the corresponding capacitor from the tunable capacitance network in an open switch state.

12. The apparatus of claim 11, wherein all closed active switching elements in switchable capacitors of the plurality of switchable capacitors in a first tunable capacitance circuit of the plurality of tunable capacitance circuits that are in a closed switch state during recording of at least one voltage sample of the one or more voltages samples are configured to:

individually dissipate power by a resistance between the second terminal and the third terminal of that closed active switching element larger than resistances over any wires of the interconnected wires that connect any of the tunable capacitance circuits to any node of the plurality of nodes in the tunable capacitance network, and collectively provide an effective capacitance of the first tunable capacitance circuit of the plurality of tunable capacitance circuits that is substantially equal to a sum of capacitances of all capacitors connected to the closed active switching elements.

13. The apparatus of claim 12, wherein the selected pairs consist of all pairs of nodes of the plurality of nodes in the tunable capacitance network.

14. The apparatus of claim 12 or 13, wherein each capacitor in each switchable capacitor of the plurality of switchable capacitors in the first tunable capacitance circuit of the plurality of tunable capacitance circuits has a different capacitance from any other capacitor in any switchable capacitor of the plurality of switchable capacitors in the first tunable capacitance circuit of the plurality of tunable capacitance circuits.

15. The apparatus of claim 12, 13 or 14, wherein each active switching element comprises one or both of an n-type metal-oxide-semiconductor transistor, or a p-type metal-oxide-semiconductor transistor and each active switching element is operated using an applied voltage that is lower than a threshold voltage of the one or both of an n-type metal-oxide-semiconductor transistor or a p-type metal-oxide-semiconductor transistor associated with the active switching element.

FIG. 1

FIG. 2

EP 4 686 948 A1

FIG. 3B

FIG. 3A

400

403

418

410

404

428

416

408

422

420

$U_s$

424

430

432

412

402

406

401

426

414

FIG. 4

FIG. 5A

FIG. 5B

FIG. 5C

FIG. 5D

FIG. 6A

FIG. 6B

FIG. 7A

FIG. 7B

EP 4 686 948 A1

FIG. 7C

FIG. 8

FIG. 9A

FIG. 9B

EP 4 686 948 A1

FIG. 10A

EP 4 686 948 A1

equilibration time

$10^1$

$10^0$

$10^{-1}$

1008

1006

Vg

1  2  3  4  5  6

FIG. 10B

FIG. 11

EP 4 686 948 A1

FIG. 12

~1300

RECEIVE PARAMETERS

1302

TUNE A PLURALITY OF TUNABLE CAPACITANCE CIRCUITS

1304

RECORD RESPECTIVE VOLTAGE SAMPLES

1306

STORE A LINEAR TRANSFORMATION OF A VECTOR OF THE
VOLTAGE SAMPLES

1308

FIG. 13

1400

1402 —— 1404 —— 1406 —— 1408 —— 1410

## FIG. 14A

1450

1458
1456
1452
1460
1454
1464
1466
1462

$$I_1 - I_2$$

## FIG. 14B

## EUROPEAN SEARCH REPORT

Europäisches
Patentamt
European
Patent Office
Office européen
des brevets

**Application Number**

EP 25 19 0658

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MELANSON DENIS ET AL: "Thermodynamic computing system for AI applications", NATURE COMMUNICATIONS, vol. 16, no. 1, 8 December 2023 (2023-12-08), XP093283113, UK ISSN: 2041-1723, DOI: 10.1038/s41467-025-59011-x Retrieved from the Internet: URL:https://arxiv.org/pdf/2312.04836> * figures 1, 2, 12, 13, 20 * ----- | 1-15 | INV. G01R19/00 G01R19/165 G01R19/25 |
| X | WO 2024/081827 A1 (NORMAL COMPUTING CORP [US]) 18 April 2024 (2024-04-18) * figures 1, 2, 6-11, 18 * ----- | 1-15 | |

**TECHNICAL FIELDS SEARCHED (IPC)**

G01R

The present search report has been drawn up for all claims

| Place of search | Date of completion of the search | Examiner |
|---|---|---|
| Munich | 21 November 2025 | Agerbaek, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................................

& : member of the same patent family, corresponding
document

EPO FORM 1503 03.82 (P4C01)

## ANNEX TO THE EUROPEAN SEARCH REPORT
## ON EUROPEAN PATENT APPLICATION NO.

EP 25 19 0658

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2025

| Patent document cited in search report | Publication date | Patent family member(s) | | Publication date |
|---|---|---|---|---|
| WO 2024081827 A1 | 18-04-2024 | EP | 4602521 A1 | 20-08-2025 |
| | | JP | 2025536288 A | 05-11-2025 |
| | | KR | 20250109682 A | 17-07-2025 |
| | | WO | 2024081827 A1 | 18-04-2024 |

EPO FORM P0459

For more details about this annex : see Official Journal of the European Patent Office, No. 12/82

**EP 4 686 948 A1**

REFERENCES CITED IN THE DESCRIPTION

**Patent documents cited in the description**

- US 63676543